# EUROPEAN PATENT APPLICATION

(11) **EP 1 814 148 A2**
(43) Date of publication of application: **01.08.2007**
(21) Application number: 06026443.9
(22) Date of filing: 20.12.2006
(51) Int. Cl.: H01L 21/28, H01L 21/336, H01L 21/8247, H01L 27/115, H01L 29/788, G11C 16/04, H01L 29/423

(54) **Floating-gate memory cell with an auxiliary gate**

(30) Priority: 27.01.2006 JP 2006018983
(71) Applicant: Renesas Technology Corp., Tokyo 100-6334 (JP)
(72) Inventor: Osabe, Taro, c/o Hitachi Ltd., 1-6-1 Marunouchi Chiyoda Tokyo 100-8220 (JP); Ishigaki, Takashi, c/o Hitachi Ltd., 1-6-1 Marunouchi Chiyoda Tokyo 100-8220 (JP); Sasago, Yoshitaka, c/o Hitachi Ltd., 1-6-1 Marunouchi Chiyoda Tokyo 100-8220 (JP)
(74) Representative: Beetz & Partner

(57) **Abstract**

A plurality of floating gates (7) are formed on a principal surface of a semiconductor substrate (1) that constitutes a nonvolatile semiconductor memory device through a first gate dielectric film (4). An auxiliary gate (9) formed on the principal surface of the semiconductor substrate through a third gate dielectric film (6) is formed on one adjacent side of the floating gates (7). A groove is formed on the other adjacent side of the floating gate, and an n-type diffusion layer (3) is formed on a bottom side of the groove. A data line of the nonvolatile semiconductor memory device is constituted by an inversion layer formed on the principal surface of the semiconductor substrate to be opposed to an auxiliary gate by applying desired voltage to the auxiliary gate, and the n-type diffusion layer.

## Description

### TECHNICAL FIELD OF THE INVENTION

The present invention relates to a semiconductor device and a technique for manufacturing the semiconductor device, and particularly relates to a technique effective to be applied to an electrically-programmable, nonvolatile semiconductor memory device.

### BACKGROUND OF THE INVENTION

There is known a so-called flash memory as an electrically programmable nonvolatile semiconductor memory device that can batch-erase information. Because of excellent portability, excellent impact durability, and capability of electrical batch erasure of the flash memory, demand for the flash memory has increasingly risen as a storage device for a small-sized portable information apparatus such as portable personal computer or digital still camera. To expand the market, it is important to satisfy both bit cost cut derived from reduction in an area of a memory cell and improvement in chip performance.

A flash memory including a stack-type memory-cell structure having a NOR-type array architecture is disclosed in, for example, Japanese Patent Application Laid-Open Publication No. 10-223868 (Patent Document 1). The memory cell is constituted by a control gate, a floating gate, a channel region, and a source diffusion layer and a drain diffusion layer formed by ion implantation. The control gates are connected to one another in row direction, thereby constituting a word line, and the source regions are connected in the diffusion layer in parallel with the word line. The source diffusion layer is formed by forming a groove in a substrate and implanting ions into an interior of the groove. It is thereby possible to reduce a resistance of a source line of the memory cell, ensure operation stability, and reduce a chip area.

Meanwhile, to reduce an area of a memory cell array so as to cut a bit cost of a flash memory, it is effective to shrink sizes of respective memory cells arranged in the memory cell array. Generally, however, in the memory cell in which charges are stored in the floating gate, a gate dielectric film cannot be made thinner from the viewpoint of reliability of data storage. Namely, the size of each memory cell cannot be shrunk in longitudinal direction. If the size of each memory cell is shrunk not in the longitudinal direction but only in lateral direction, the conventional idea of scaling cannot be applied and in general, punch-trough occurs to the memory cell due to short channel effect. And, in reducing the area of the memory cell array, an area of a wiring of the memory cell should also be reduced, accordingly. If the area of the wiring is reduced, a resistance of the wiring is increased. The increased resistance of the wiring causes another problem of decelerating read speed.

Namely, in the flash memory (particularly flash memory having a so-called AND/NOR array architecture), when the area of each of all memory cells is reduced, there are two challenges: (1) to realize a enough channel length between a source and a drain so as to suppress the punch-through resulting from the short channel effect, and (2) to reduce an electric resistance of a diffusion layer or an inversion layer that constitutes a data line so as to ensure read speed. In other words, it is an important problem how to downsize each memory cell of the flash memory with satisfying the requirements (1) and (2).

The memory cell structure disclosed the Patent Document 1 is intended to satisfy the requirements. The memory cell structure disclosed the Patent Document 1 in the generation of using a wider design rule than, for example, a 130-nanometer design rule can satisfy the requirements (1) and (2). However, in newer generation of the design rule, a data-line pitch is further shrunk and the distance between the source and the drain is made shorter. If so, a depth of the diffusion layer for the source or drain of the memory cell becomes nonnegligible. As a result, punch-through occurs to a deep part of the substrate, and the reduction in data line pitch faces its limit.

Moreover, to make the diffusion layer that forms the data line shallower, reduction in an impurity concentration of the diffusion layer is considered. However, it causes increase of the resistance of the data line, and as a result, the requirement (2) cannot be satisfied.

### SUMMARY OF THE INVENTION

It is, therefore, an object of the present invention to provide a technique capable of downsizing a memory cell of a semiconductor device.

The above and other objects as well as novel features of the preset invention will be readily apparent from the description of the specification and the accompanying drawings.

A typical aspect of the present invention is as follows.

According to the typical aspect of the present invention, there is provided a semiconductor device comprising a memory cell, the memory cell including one data line formed by an inversion layer formed on a principal surface of a semiconductor substrate and the other data line formed by a diffusion layer, wherein the diffusion layer is formed at a deep position apart from the principal surface of the semiconductor device.

An advantage attained by the typical aspect of the present invention is described below.

In the typical aspect of the present invention, memory cell of a semiconductor device, particularly a nonvolatile semiconductor memory device can be downsized.

### BRIEF DESCRIPTION OF THE DRAWINGS

FIG. 1 is a principal part plan view showing a configuration of a memory cell array of a nonvolatile semiconductor memory device according to the first embodiment of the present invention;
FIG. 2 is a principal part cross-sectional view of a semiconductor substrate taken along a line A-A' shown in FIG. 1;
FIG. 3 is a principal part cross-sectional view of a semiconductor substrate taken along a line B-B' shown in FIG. 1 ;
FIG. 4 is a principal part cross-sectional view of a semiconductor substrate taken along a line C-C' shown in FIG. 1;
FIG. 5 is a principal part cross-sectional view of a semiconductor substrate taken along a line D-D' shown in FIG. 1;
FIG. 6 is a principal-part cross-sectional view of a semiconductor substrate taken along a line E-E' shown in FIG. 1;
FIG. 7 is an equivalent circuit diagram of a principal part of a memory circuit for explaining a data read operation performed by the nonvolatile semiconductor memory device shown in FIG. 1;
FIG. 8 is an equivalent circuit diagram of a principal part of a memory circuit for explaining a data write operation performed by the nonvolatile semiconductor memory device shown in FIG. 1;
FIG. 9 is a cross-sectional view of a principal part of the semiconductor substrate during a step of manufacturing the nonvolatile semiconductor memory device shown in FIG. 1;
FIG. 10 is a plan view of a principal part of the semiconductor substrate during a step of manufacturing the nonvolatile semiconductor memory device subsequent to FIG. 9;
FIG. 11 is a cross-sectional view of a principal part of the semiconductor substrate taken along the line B-B' of FIG. 10;
FIG. 12 is a principal part cross-sectional view of the semiconductor substrate during a step of manufacturing the nonvolatile semiconductor memory device subsequent to FIGs. 10 and 11;
FIG. 13 is a principal part cross-sectional view of the semiconductor substrate during a step of manufacturing the nonvolatile semiconductor memory device subsequent to FIG. 12;
FIG. 14 is a principal part cross-sectional view of the semiconductor substrate during a step of manufacturing the nonvolatile semiconductor memory device subsequent to FIG. 13;
FIG. 15 is a principal part cross-sectional view of the semiconductor substrate during a step of manufacturing the nonvolatile semiconductor memory device subsequent to FIG. 14;
FIG. 16 is a principal part cross-sectional view of the semiconductor substrate during a step of manufacturing the nonvolatile semiconductor memory device subsequent to FIG. 15;
FIG. 17 is a principal part cross-sectional view of the semiconductor substrate during a step of manufacturing the nonvolatile semiconductor memory device subsequent to FIG. 16;
FIG. 18 is a principal part cross-sectional view of the semiconductor substrate during a step of manufacturing the nonvolatile semiconductor memory device subsequent to FIG. 17;
FIG. 19 is a principal part cross-sectional view of the semiconductor substrate during a step of manufacturing the nonvolatile semiconductor memory device subsequent to FIG. 18;
FIG. 20 is a principal part cross-sectional view of the semiconductor substrate during a step of manufacturing the nonvolatile semiconductor memory device subsequent to FIG. 19;
FIG. 21 is a principal part plan view of the semiconductor substrate during a step of manufacturing the nonvolatile semiconductor memory device subsequent to FIG. 19;
FIG. 22 is a principal part cross-sectional view of the semiconductor substrate taken along a line F-F' of FIG. 21;
FIG. 23 is a principal part cross-sectional view of the semiconductor substrate during a step of manufacturing the nonvolatile semiconductor memory device subsequent to FIGs. 21 and 22;
FIG. 24 is a principal part cross-sectional view of the semiconductor substrate during a step of manufacturing the nonvolatile semiconductor memory device subsequent to FIG. 23;
FIG. 25 is a principal part cross-sectional view of the semiconductor substrate taken along a line corresponding to the line C-C' of FIG. 1 after the same step as that shown in FIG. 24;
FIG. 26 is a principal part cross-sectional view of a semiconductor substrate showing a modification of a step of manufacturing the nonvolatile semiconductor memory device;
FIG. 27 is a principal part cross-sectional view of the semiconductor substrate taken along a line corresponding to the line C-C' of FIG. 1 after the same step as that shown in FIG. 26;
FIG. 28 is a principal part cross-sectional view of the semiconductor substrate during a step of manufacturing the nonvolatile semiconductor memory device subsequent to FIGs. 24 and 25;
FIG. 29 is a principal part cross-sectional view of the semiconductor substrate taken along a line corresponding to the line C-C' of FIG. 1 after the same step as that shown in FIG. 28;
FIG. 30 is a principal part cross-sectional view of a semiconductor substrate showing a modification of a step of manufacturing the nonvolatile semiconductor memory device;
FIG. 31 is a graph showing comparison between roll-off characteristics of the nonvolatile semiconductor memory device shown in FIG. 1 and those of a technique studied by the inventors of the present invention;
FIG. 32 is a principal part plan view showing a configuration of a memory array of a nonvolatile semiconductor memory device according to the second embodiment of the present invention;
FIG. 33 is a principal part cross-sectional view of a semiconductor substrate taken along a line G-G' of FIG. 32;
FIG. 34 is a principal part cross-sectional view of the semiconductor substrate during a step of manufacturing the nonvolatile semiconductor memory device shown in FIG. 32;
FIG. 35 is a principal part cross-sectional view of the semiconductor substrate during a step of manufacturing the nonvolatile semiconductor memory device subsequent to FIG. 34;
FIG. 36 is an equivalent circuit of a principal part of a memory circuit for explaining a data read operation performed by the nonvolatile semiconductor memory device shown in FIG. 32;
FIG. 37 is an equivalent circuit of a principal part of a memory circuit for explaining a data write operation performed by the nonvolatile semiconductor memory device shown in FIG. 32;
FIG. 38 is an equivalent circuit diagram of a principal part of the memory circuit in the nonvolatile semiconductor memory device according to the second embodiment;
FIG. 39 is a waveform view showing an example of waveforms of voltages applied to respective electrodes shown in FIG. 38;
FIG. 40 is a principal part plan view showing a configuration of a memory cell array of a nonvolatile semiconductor memory device according to a third embodiment of the present invention;
FIG. 41 is a principal part cross-sectional view taken along a line H-H' of FIG. 40;
FIG. 42 is a principal part cross-sectional view of the semiconductor substrate during a step of manufacturing the nonvolatile semiconductor memory device shown in FIG. 40;
FIG. 43 is a principal part cross-sectional view of the semiconductor substrate during a step of manufacturing the nonvolatile semiconductor memory device subsequent to FIG. 42;
FIG. 44 is a principal part cross-sectional view of the semiconductor substrate during a step of manufacturing the nonvolatile semiconductor memory device subsequent to FIG. 43;
FIG. 45 is a principal part cross-sectional view of the semiconductor substrate during a step of manufacturing the nonvolatile semiconductor memory device subsequent to FIG. 44;
FIG. 46 is a principal part cross-sectional view of the semiconductor substrate during a step of manufacturing the nonvolatile semiconductor memory device subsequent to FIG. 45;
FIG. 47 is a principal part cross-sectional view of the semiconductor substrate during a step of manufacturing the nonvolatile semiconductor memory device subsequent to FIG. 46;
FIG. 48 is a principal part cross-sectional view of the semiconductor substrate during a step of manufacturing the nonvolatile semiconductor memory device subsequent to FIG. 47;
FIG. 49 is a principal part cross-sectional view of the semiconductor substrate during a step of manufacturing the nonvolatile semiconductor memory device subsequent to FIG. 48;
FIG. 50 is a principal part cross-sectional view of the semiconductor substrate during a step of manufacturing the nonvolatile semiconductor memory device subsequent to FIG. 49;
FIG. 51 is a principal part cross-sectional view of the semiconductor substrate during a step of manufacturing the nonvolatile semiconductor memory device subsequent to FIG. 50;
FIG. 52 is a principal part cross-sectional view of the semiconductor substrate during a step of manufacturing the nonvolatile semiconductor memory device subsequent to FIG. 51;
FIG. 53 is a principal part cross-sectional view of the semiconductor substrate during a step of manufacturing the nonvolatile semiconductor memory device subsequent to FIG. 52;
FIG. 54 is a principal part cross-sectional view of the semiconductor substrate during a step of manufacturing the nonvolatile semiconductor memory device subsequent to FIG. 53;
FIG. 55 is a principal part cross-sectional view of the semiconductor substrate during a step of manufacturing the nonvolatile semiconductor memory device subsequent to FIG. 54;
FIG. 56 is a principal part cross-sectional view of the semiconductor substrate during a step of manufacturing the nonvolatile semiconductor memory device subsequent to FIG. 55;
FIG. 57 is a principal part cross-sectional view of the semiconductor substrate during a step of manufacturing the nonvolatile semiconductor memory device subsequent to FIG. 56;
FIG. 58 is a principal part cross-sectional view of the semiconductor substrate during a step of manufacturing the nonvolatile semiconductor memory device subsequent to FIG. 57;
FIG. 59 is a principal part cross-sectional view of the semiconductor substrate during a step of manufacturing the nonvolatile semiconductor memory device subsequent to FIG. 58;
FIG. 60 is a principal part cross-sectional view of the semiconductor substrate during a step of manufacturing the nonvolatile semiconductor memory device subsequent to FIG. 59;
FIG. 61 is a principal part plan view showing a configuration of a memory cell array of a nonvolatile semiconductor memory device according to the fourth embodiment of the present invention;
FIG. 62 is a principal part cross-sectional view taken along a line I-I' of FIG. 61;
FIG. 63 is a principal part cross-sectional view taken along a line J-J' of FIG. 61;
FIG. 64 is an equivalent circuit diagram of a principal part of a memory circuit for explaining a data read operation performed by the nonvolatile semiconductor memory device shown in FIG. 61;
FIG. 65 is an equivalent circuit diagram of a principal part of a memory circuit for explaining a data write operation performed by the nonvolatile semiconductor memory device shown in FIG. 61;
FIG. 66 is an equivalent circuit diagram of a principal part of a memory circuit for explaining a data erasure operation performed by the nonvolatile semiconductor memory device shown in FIG. 61;
FIG. 67 is a principal part cross-sectional view of the semiconductor substrate during a step of manufacturing the nonvolatile semiconductor memory device shown in FIG. 61;
FIG. 68 is a principal part cross-sectional view of the semiconductor substrate during a step of manufacturing the nonvolatile semiconductor memory device subsequent to FIG. 67;
FIG. 69 is a principal part cross-sectional view of the semiconductor substrate during a step of manufacturing the nonvolatile semiconductor memory device subsequent to FIG. 68;
FIG. 70 is a principal part cross-sectional view of the semiconductor substrate during a step of manufacturing the nonvolatile semiconductor memory device subsequent to FIG. 69;
FIG. 71 is a principal part cross-sectional view of the semiconductor substrate during a step of manufacturing the nonvolatile semiconductor memory device subsequent to FIG. 70;
FIG. 72 is a principal part cross-sectional view of the semiconductor substrate during a step of manufacturing the nonvolatile semiconductor memory device subsequent to FIG. 71;
FIG. 73 is a principal part cross-sectional view of the semiconductor substrate during a step of manufacturing the nonvolatile semiconductor memory device subsequent to FIG. 72;
FIG. 74 is a principal part cross-sectional view of the semiconductor substrate during a step of manufacturing the nonvolatile semiconductor memory device subsequent to FIG. 73;
FIG. 75 is a principal part cross-sectional view of the semiconductor substrate during a step of manufacturing the nonvolatile semiconductor memory device subsequent to FIG. 74;
FIG. 76 is a principal part cross-sectional view of the semiconductor substrate during a step of manufacturing the nonvolatile semiconductor memory device subsequent to FIG. 75; and
FIG. 77 is a principal part cross-sectional view of the semiconductor substrate showing a modification of a step of manufacturing the nonvolatile semiconductor memory device.

### DESCRIPTION OF THE PREFERRED EMBODIMENTS

Embodiments of the present invention will be described in separated to some embodiments hereinafter. It is to be noted that the embodiments are not irrelevant of one another but relevant to one another such that one is a modification, a detailed embodiment, supplementary embodiment or the like of the other or all the other embodiments unless specified otherwise. Furthermore, in the drawings for describing the embodiments, constituent elements identical in function are basically denoted by the same reference symbols, respectively and will be not repeatedly described. The embodiments of the present invention will be described with reference to the accompanying drawings

### (First Embodiment)

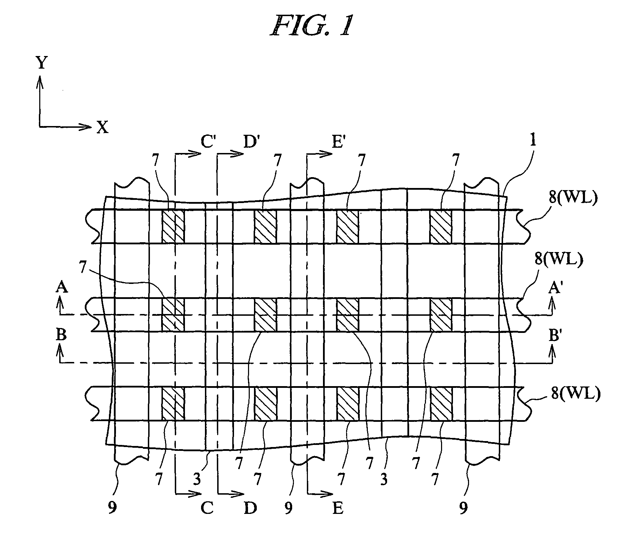

FIG. 1 is a principal part plan view showing a configuration of a memory array of a nonvolatile semiconductor memory device according to a first embodiment of the present invention.

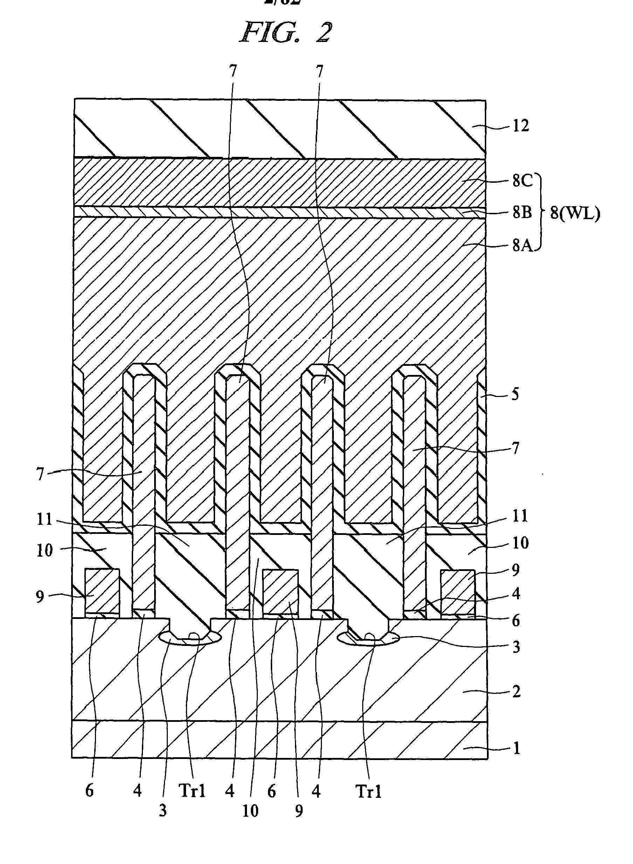

FIG. 2 is a principal part cross-sectional view of a semiconductor substrate taken along a line A-A' shown in FIG. 1.

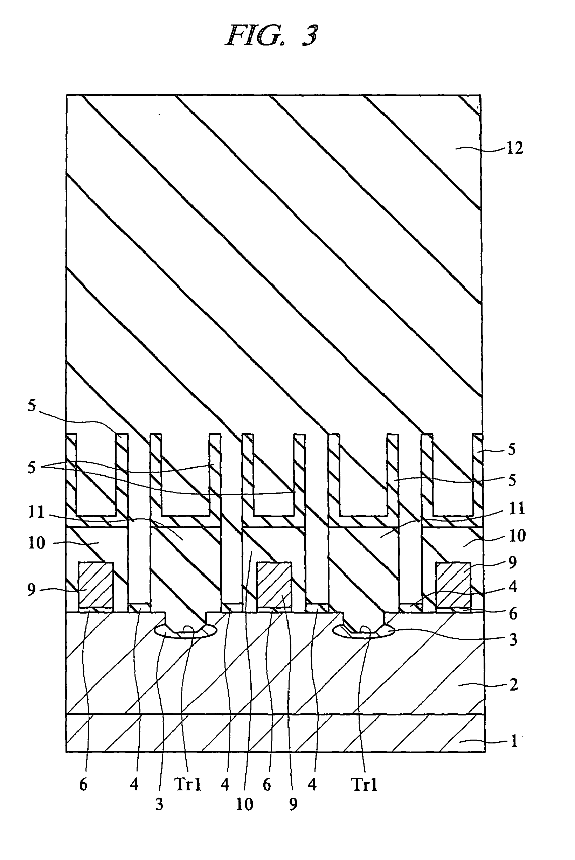

FIG. 3 is a principal part cross-sectional view of a semiconductor substrate taken along a line B-B' shown in FIG. 1.

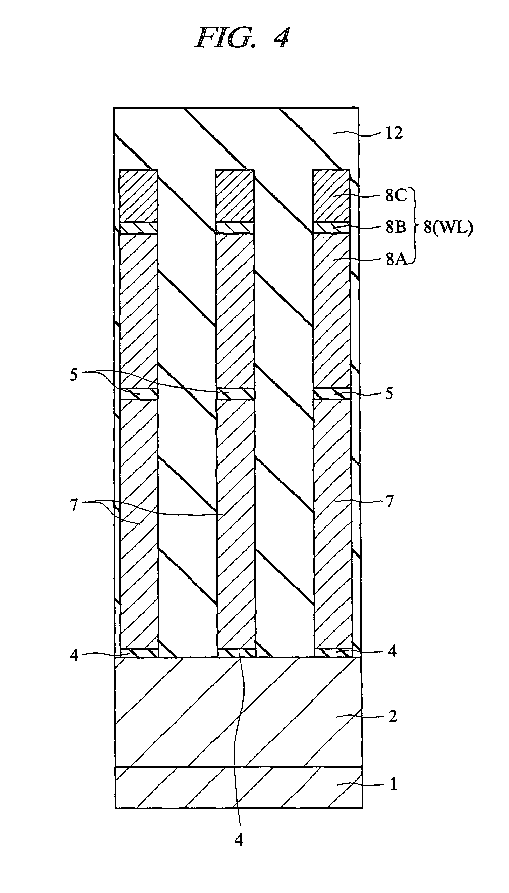

FIG. 4 is a principal part cross-sectional view of a semiconductor substrate taken along a line C-C' shown in FIG. 1.

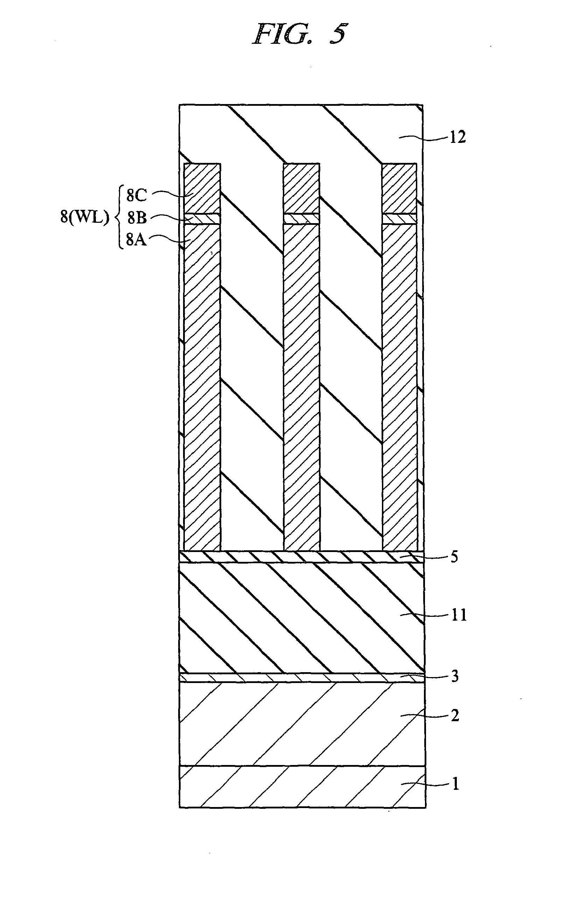

FIG. 5 is a principal part cross-sectional view of a semiconductor substrate taken along a line D-D' shown in FIG. 1.

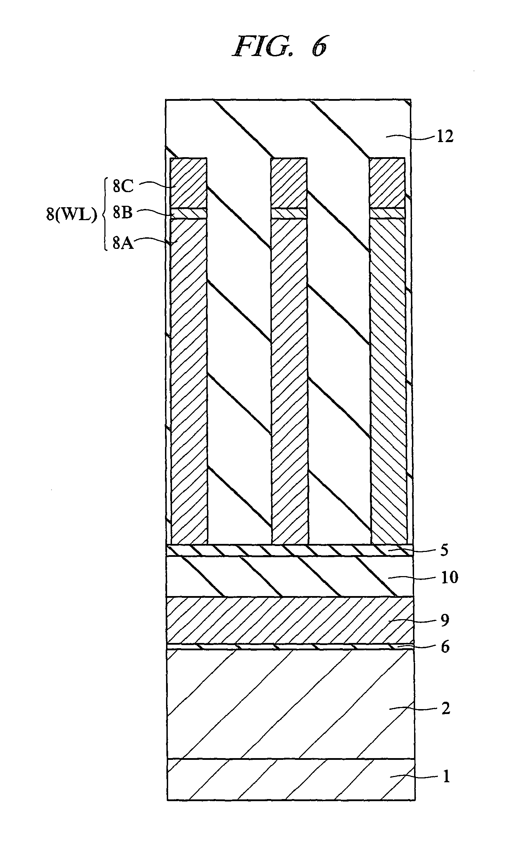

FIG. 6 is a principal part cross-sectional view of a semiconductor substrate taken along a line E-E' shown in FIG. 1.
In FIG. 1, some of constituent elements such as a dielectric film are not shown for clarity.

The nonvolatile semiconductor memory device according to the first embodiment is a so-called AND flash memory capable of electrically erasing and programming data. A semiconductor substrate (hereinafter, "substrate") 1 that constitutes the flash memory according to the first embodiment is made of, for example, a single crystalline silicon (Si), and has a principal surface and a rear surface located opposite to each other in a thickness direction of the substrate 1. A memory array including a plurality of memory cells is formed in a p-type well 2 on the principal surface of the substrate 1.

Each of the memory cells is constituted by a MOS·FET (Metal-Oxide-Semiconductor Field Effect Transistor) that includes an n-type diffusion layer 3, a floating gate (first gate electrode) 7, a control gate (second gate electrode) 8, and an auxiliary gate (third gate electrode) 9. In the specification, the memory cell will be described as the MOS·FET by way of example. However, the memory cell is not limited to the MOS·FET but may be constituted by a so-called MIS·FET (Metal-Insulator-Semiconductor Field Effect Transistor).

The n-type diffusion layer 3 is formed by an n-type region buried in the p-type well 2. Namely, a groove Tr1 extending continuously in a column direction (Y direction: "second direction") so as to pass through two adjacent floating gates 7, and the n-type diffusion layer 3 is formed on a bottom side of the groove Tr1. The bottom of the groove Tr1 is formed so as to be slightly recessed with respect to the principal surface of the substrate 1 on which the floating gates 7 and the auxiliary gates 9 are formed. Accordingly, the n-type diffusion layer 3 is formed at a position slightly apart in a depth direction from the principal surface of the substrate 1 on which the floating gates 7 and the auxiliary gate 9 are formed.

By thus burying the n-type diffusion layer 3, the n-type diffusion layer 3 can be provided offset from each floating gate 7 adjacent thereto. Namely, the n-type diffusion layer 3 can be provided apart from a height position of the principal surface of the substrate 1 on which the floating gates 7 are formed, to a thickness direction of the substrate 1. By doing so, even if a plane interval between the n-type diffusion layer 3 and the floating gate 7 adjacent thereto is small, it is possible to make the distance therebetween large. Due to this, a channel length of each memory cell can be made large, thereby making it possible to suppress or prevent punch-through. In other words, the memory cell (MOS·FET memory cell transistor) can exhibit high tolerance against short channel effect (hereinafter, "high short-channel-effect tolerance"). It is, therefore, possible to narrow a pitch between the memory cell and a data line (i.e., pitch between data lines adjacent to each other), and downsize the memory cell of the flash memory. An area of the memory cell array can be thereby reduced. Furthermore, because of no need to reduce an impurity concentration of the n-type diffusion layer 3, it is possible to ensure that each data line is low in resistance. It is, therefore, possible to ensure that the flash memory can perform data read and write operations in high speed.

Moreover, the n-type diffusion layers 3 of a plurality of memory cells arranged in the Y direction in FIG. 1 are connected to one another and constitute a local data line extending in the Y direction.

The floating gate 7 of the memory cell is formed on the p-type well 2 and constituted by an n-type polycrystalline silicon film through a first gate dielectric film 4. The floating gate 7 is electrically insulated from the other components and formed in a floating state. Namely, the floating gate 7 is insulated from the control gate 8 by a second gate dielectric film 7. Furthermore, the floating gate 7 is insulated from the auxiliary gate 9 by a silicon dioxide film 10 formed therebetween. The floating gate 7 is insulated from the p-type well 2 by a first gate dielectric film 4. The plural floating gates 7 are insulated from one another by silicon dioxide films 10, 11, and 12. A part of the silicon dioxide film 11 is buried in the trench Tr1.

The control gate 8 is formed above the floating gate 7 through the second gate dielectric film 5. The control gate 8 is made of a polymetal film in which, for example, an n-type polycrystalline silicon film 8A, a tungsten nitride (WN) film 8B, and a tungsten (W) film 8C are deposited in this order. Control gates of a plurality of memory cells arranged in a row direction (X direction: "first direction") orthogonal to the Y direction shown in FIG. 1 are connected to one another and constitute a word line WL extending in the row direction. In other words, on the word line WL, it is the control gate 8 that is two-dimensionally overlapped with the floating gate 7. In this manner, word lines WL are arranged to be orthogonal to the n-type diffusion layer 3 (local data lines). The word lines WL are insulated from one another by the silicon dioxide film 12.

The auxiliary gate 9 is formed on the p-type well 2 through a third gate dielectric film 6 and constituted by an n-type polycrystalline silicon film. Moreover, auxiliary gates 9 of a plurality of memory cells arranged in the Y direction of FIG. 1 are connected to one another. Namely, the auxiliary gates 9 are arranged along the n-type diffusion layer 3 (local data line) and arranged to be orthogonal to the word lines WL. The auxiliary gate 9 is insulated from the control gate 8 by the second gate dielectric film 5 and the silicon dioxide film 10. The auxiliary gate 9 is insulated from the p-type well 2 by the third gate dielectric film 6.

A drain and a source used when data is read from such a memory cell are formed by an inversion layer that is formed on the p-type well 2 which is opposed to the auxiliary gate 9 when a positive voltage is applied to the auxiliary gate 9, and by the n-type diffusion layer 3, respectively. Namely, by forming one of a pair of data lines by the n-type diffusion layer 3, a resistance of each local data line can be reduced as compared with an instance in which the pair of data lines are both formed by inversion layers. It is, therefore, possible to ensure that the flash memory can perform high speed operations such as data read and write operations.

Moreover, the flash memory according to the first embodiment adopts a so-called contactless memory cell array configuration in which a contact hole for connecting the source/drain to the data line is not formed for every memory cell. It is thereby possible to reduce the area of the memory cell array.

As described above, according to the first embodiment, a pitch between the adjacent data lines can be reduced while keeping the resistance of the data line low and ensuring high short-channel-effect tolerance. Because of capability of reducing the resistance of the data line, the performance of the flash memory can be improved. Furthermore, because of capability of ensuring the high short-channel-effect tolerance, an operation failure resulting from the punch-through of the memory cell can be prevented, and the operation reliability of the flash memory can be improved. In other words, an area of a semiconductor chip on which the flash memory is formed can be reduced while ensuring the performance and the operation reliability of the flash memory. Besides, because the area of the semiconductor chip can be reduced, cost reduction can be realized.

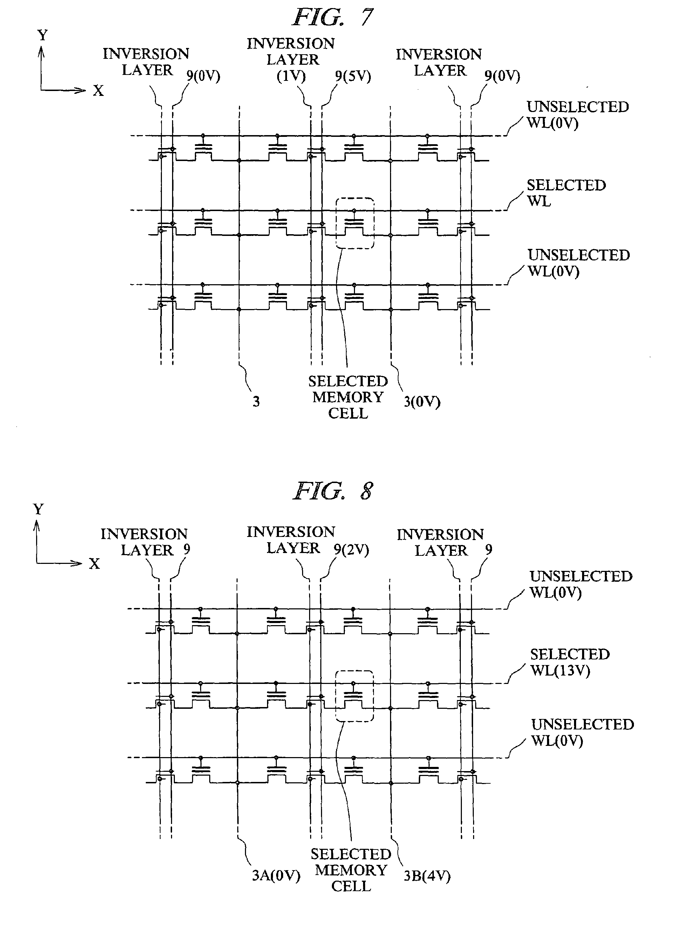

Operations performed by the memory cell will next be described using equivalent circuits, with reference to FIGs. 7 and 8.

First of all, as shown in FIG. 7, during a data read operation, a voltage of about 5V is applied to the auxiliary gate 9 adjacent to a selected memory cell, the inversion layer is formed in a part of the p-type well 2 of substrate 1 which is opposed to the auxiliary gate 9, and the formed inversion layer is used as a drain. A voltage of about 1V is applied to the drain. The n-type diffusion layer 3 adjacent to the selected memory cell is used as a source. A voltage of either 0V or negative voltage such as about -2 volt is applied to non-selected word lines, and a voltage is applied to the control gate 8 (word line WL) of the selected memory cell so as to determine a threshold voltage of the memory cell.

During a data write operation, as shown in FIG. 8, two n-type diffusion layers 3 are employed. Voltages of 0V, about 4V, about 13V, and about 13V are applied to a source-side n-type diffusion layer 3A, a drain-side n-type diffusion layer 3B, the auxiliary gate 9 near the selected memory cell, and the control gate 8 (word line WL) of the selected memory cell, respectively so as to keep a voltage of the p-type well 2 to 0V. By doing so, a channel is formed from the source to the drain. Moreover, since the voltage of the auxiliary gate 9 is about 2V, a resistance of the channel formed in the p-type well 2 opposed to the auxiliary gate 9 becomes high. Therefore, hot electrons generated in a source-side channel formed in the p-type well 2 opposed to the floating gate of the selected memory cell are injected into the floating gate 7 of the selected memory cell.

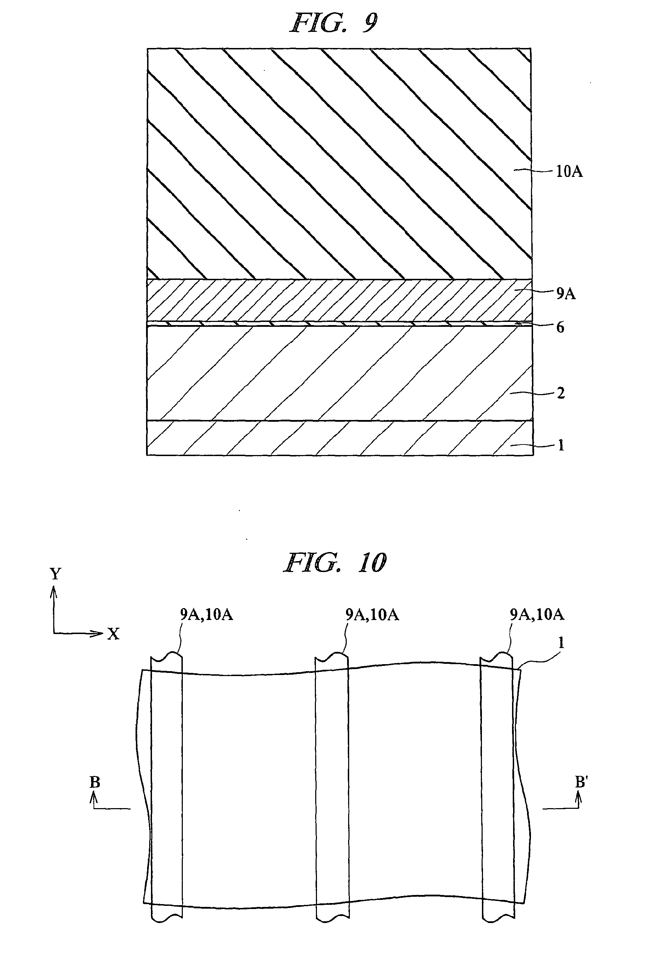

A method of manufacturing the flash memory thus configured will next be described with reference to FIGs. 9 to 30 in order of steps. Among FIGs. 9 to 25, cross-sectional views are those taken along a line B-B' corresponding that of FIG. 1 unless specified otherwise.

First, as shown in FIG. 9, impurity ions are implanted into the substrate 1 (which is a semiconductor thin plate in the plane form of generally circular referred to as "semiconductor wafer" at this stage) made of p-type single crystalline silicon, thereby forming the p-type well 2. Thereafter, the third gate dielectric film 6 made of, for example, silicon dioxide is formed on the p-type well 2 by thermal oxidation. Using CVD (chemical vapor deposition), an n-type polycrystalline silicon film 9A and a silicon dioxide film 10A are continuously deposited on the third gate dielectric film 6.

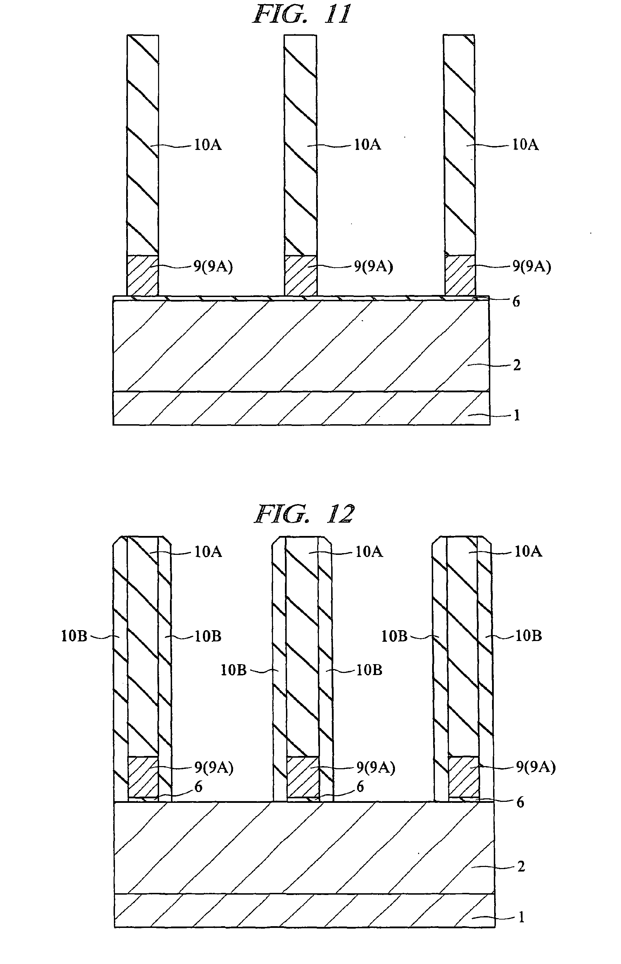

Referring to FIGs. 10 and 11, dry etching is performed using a photoresist film as a mask, thereby patterning the silicon dioxide film 10A and the n-type polycrystalline silicon film 9A (auxiliary gate 9). At this moment, the silicon dioxide film 10A and the polycrystalline silicon film 9A are in a pattern of a plurality of stripes extending in the Y direction. FIG. 10 is a principal part plan view of the memory cell array of the flash memory after this step and FIG. 11 is a cross-sectional view of FIG. 10 taken along the line B-B'.

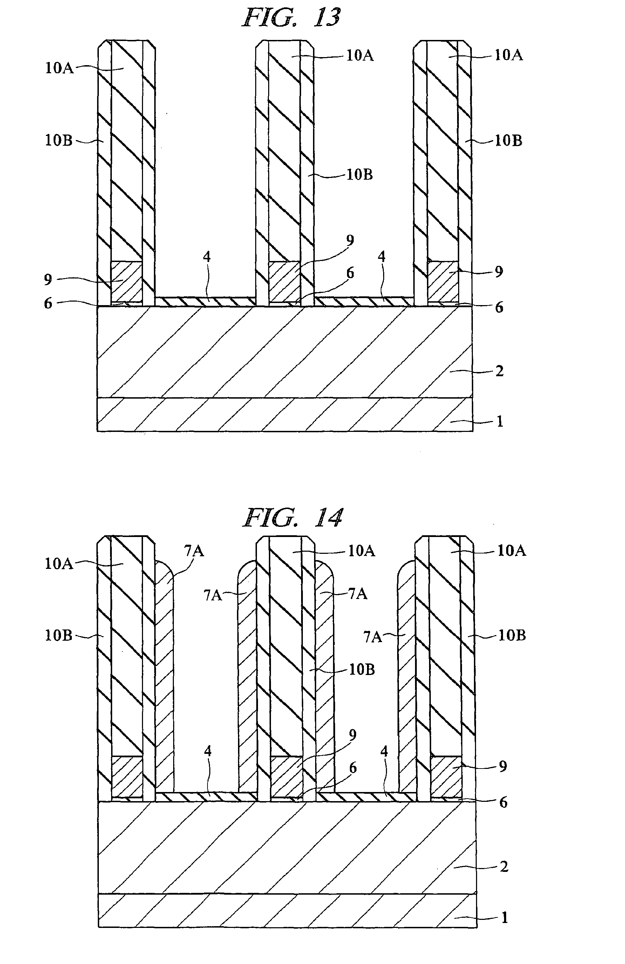

As shown in FIG. 12, a silicon dioxide film, for example, is deposited by the CVD or the like and then etched back by anisotropic etching, hereby forming a sidewall 10B made of the silicon dioxide film on sidewalls of strip patterns of the third gate dielectric film 6, the n-type polycrystalline silicon film 9A (auxiliary gate 9), and the silicon dioxide film 10A, respectively. As shown in FIG. 13, by performing, for example, the thermal oxidation again, the first gate dielectric film 4 made of the silicon dioxide film is formed on the p-type well 2.

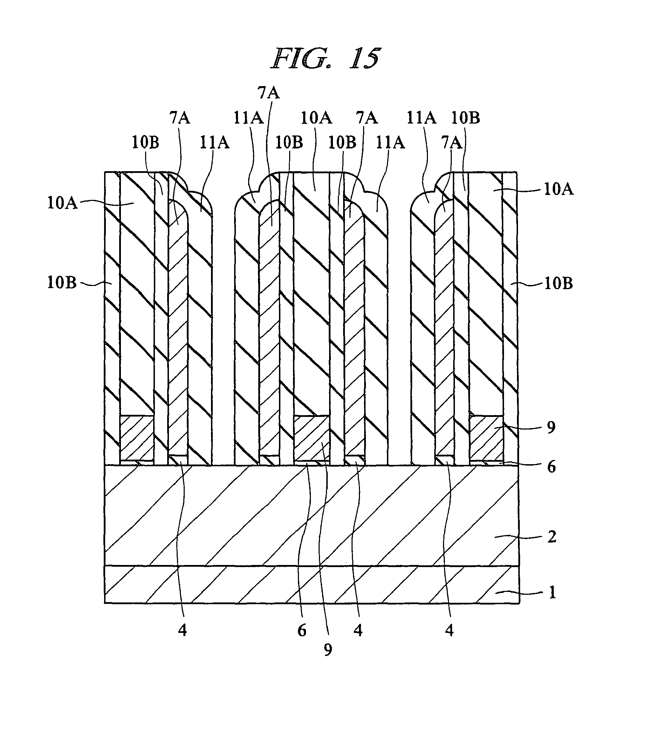

As shown in FIG. 14, n-type polycrystalline silicon is deposited by, for example, the CVD and then etched back by anisotropic etching, thereby forming a sidewall 7A made of the n-type polycrystalline silicon on the sidewall 10B. Thereafter, as shown in FIG. 15, the silicon dioxide film is deposited by, for example, the CVD and then etched back by anisotropic etching, thereby forming a sidewall 11A made of the silicon dioxide film on each of the sidewalls 7A and 10B.

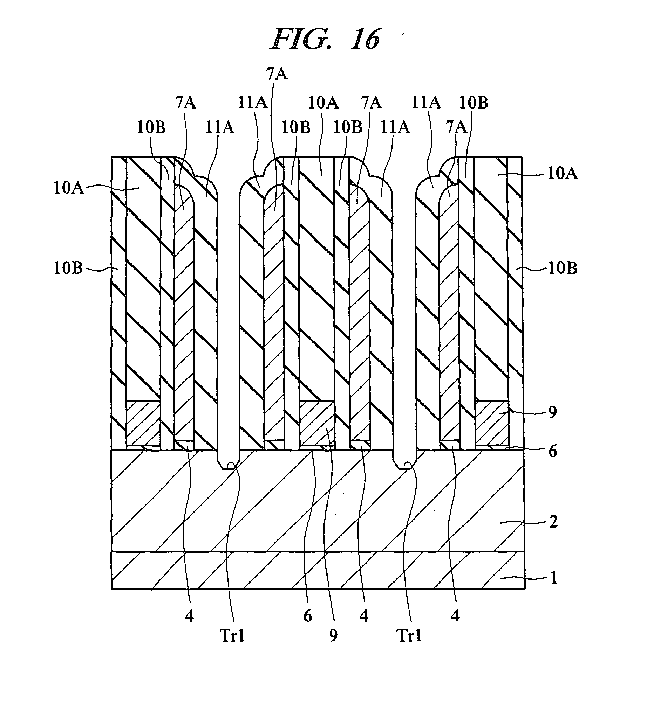

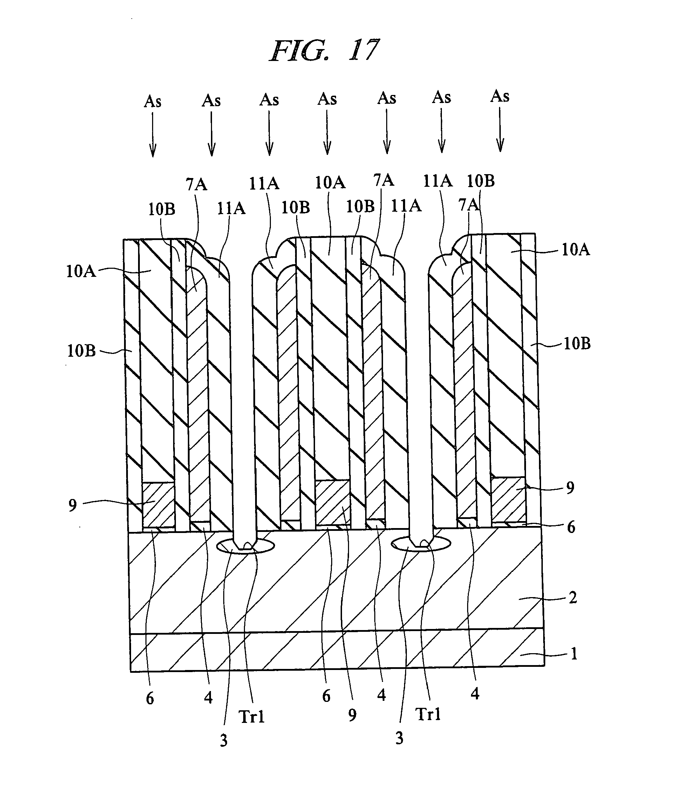

As shown in FIG. 16, silicon is subjected to anisotropic etching to form the groove Tr1 in the principal surface of the substrate 1 using the sidewall 11A and the silicon dioxide film 10A as a mask. As shown in FIG. 17, impurity ions of, for example, arsenic (As) ions are implanted into the principal surface of the substrate 1 using the sidewall 11A and the silicon dioxide film 10A as a mask, i.e., implanted to the bottom side of the groove Tr1, and necessary heat treatment is performed, thereby forming the n-type diffusion layer 3 on the bottom side of the groove Tr1 in the p-type well 2.

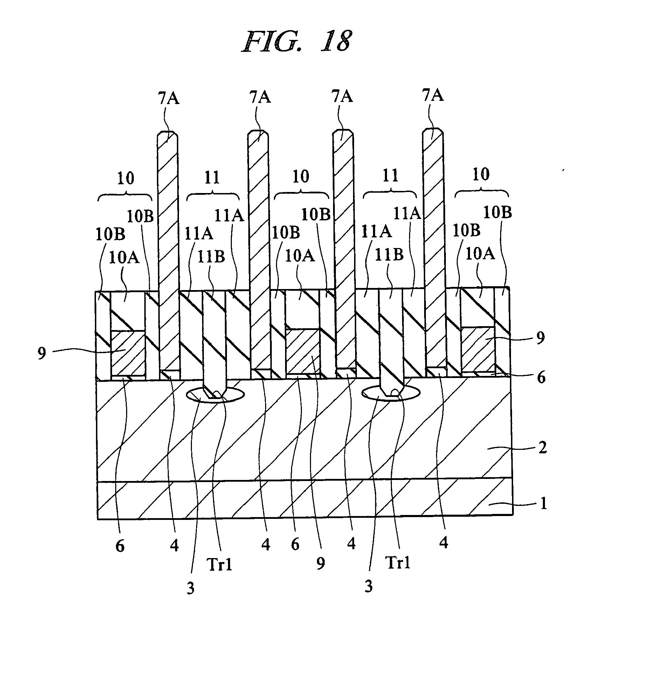

As shown in FIG. 18, a silicon dioxide film 11B is deposited by the CVD or the like and flattened by CMP (chemical-mechanical polishing), and the silicon dioxide films 10A and 11B and the sidewalls 10B and 11A are then anisotropically etched. At this moment, etching conditions are adjusted so as to round an upper portion of the sidewall 7A made of the n-type polycrystalline silicon. The silicon dioxide film 10A and the sidewall 10B will be collectively referred to as "silicon dioxide film 10" hereinafter. Furthermore, the sidewall 11A and the silicon dioxide film 11B will be collectively referred to as "silicon dioxide film 11" hereinafter.

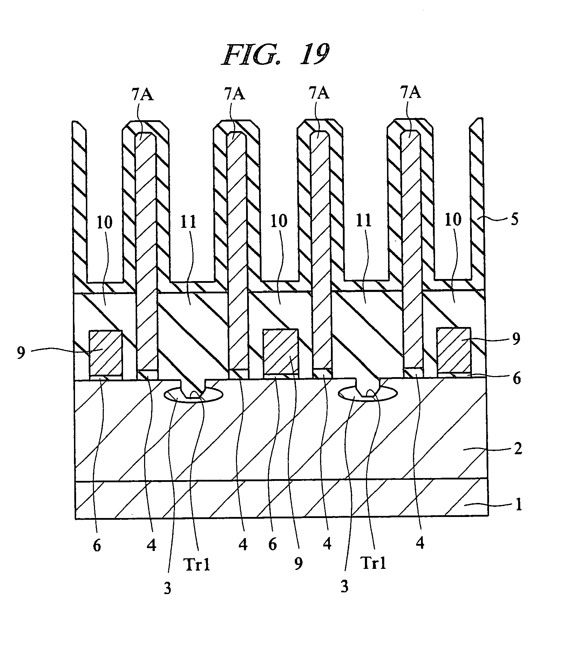

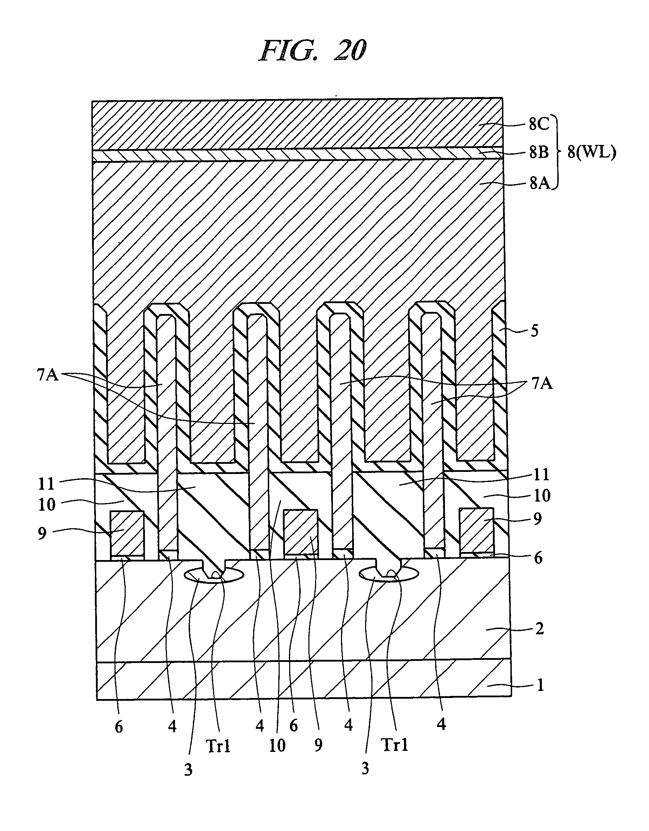

As shown in FIG. 19, a silicon dioxide film is deposited by the CVD, thereby forming the second gate dielectric film 5. The second gate dielectric film 5 can be constituted by a three-layer film in which silicon dioxide, silicon nitride, and silicon dioxide are deposited from the bottom. Thereafter, as shown in FIG. 20, an n-type polycrystalline silicon film 8A, a tungsten nitride film 8B, and a tungsten film 8C are deposited on the second gate dielectric film 5 from the bottom by the CVD and sputtering.

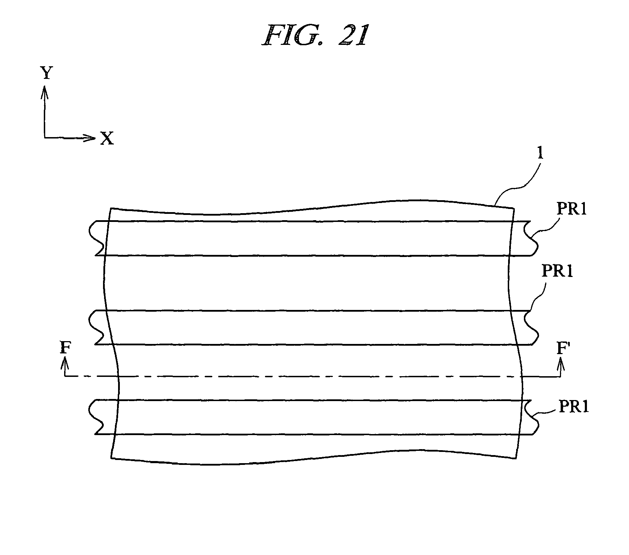

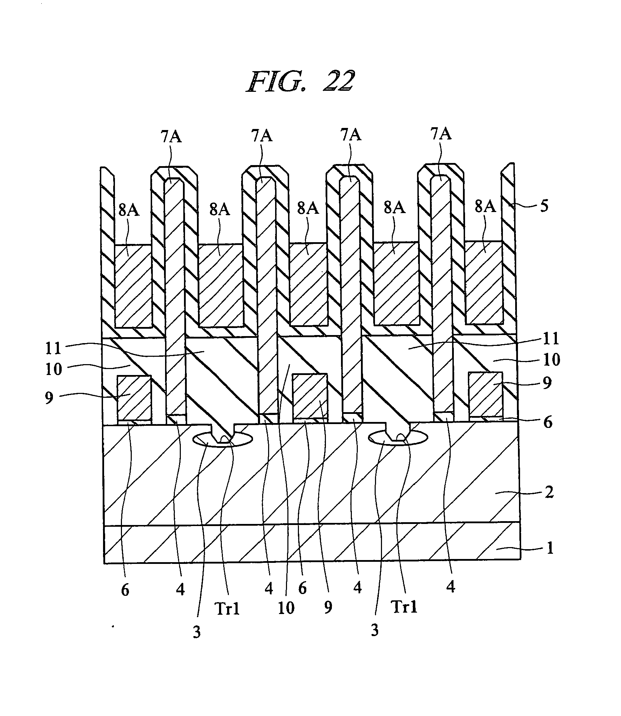

As shown in FIG. 21, a pattern of a plurality of photoresists PR1 extending in X direction is formed by lithography, and the tungsten film 8C and the tungsten nitride film 8B are anisotropically etched using the photoresists PR1 as a mask. Thereafter, the n-type polycrystalline silicon film 8A under the tungsten nitride film 8B is anisotropically etched. At this moment, as shown in FIG. 22, the n-type polycrystalline silicon film 8A is etched not entirely but partially to leave it between patterns of the photoresists PR1. FIG. 22 is a cross-sectional view taken along a line F-F' of FIG. 21. The lithography is a series of resist pattern processing including coating photoresist films, exposure, development and the like.

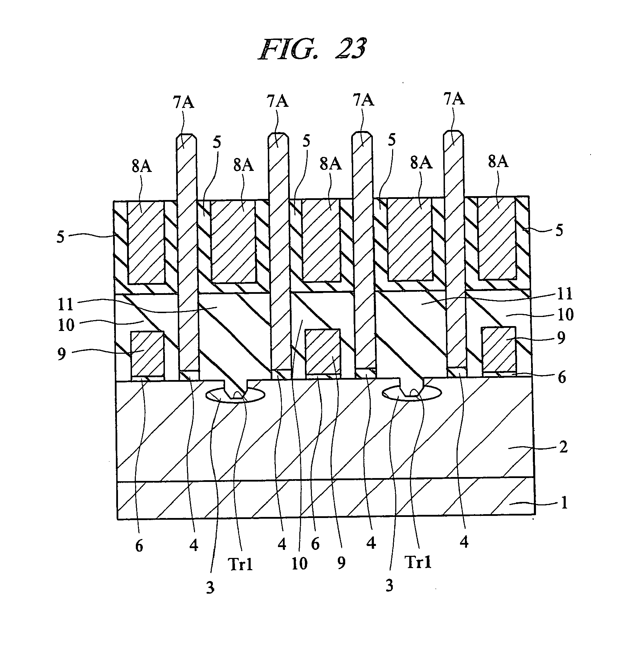

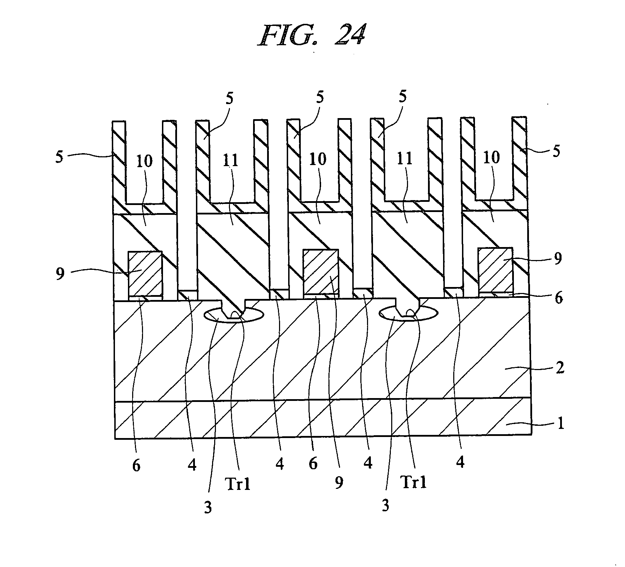

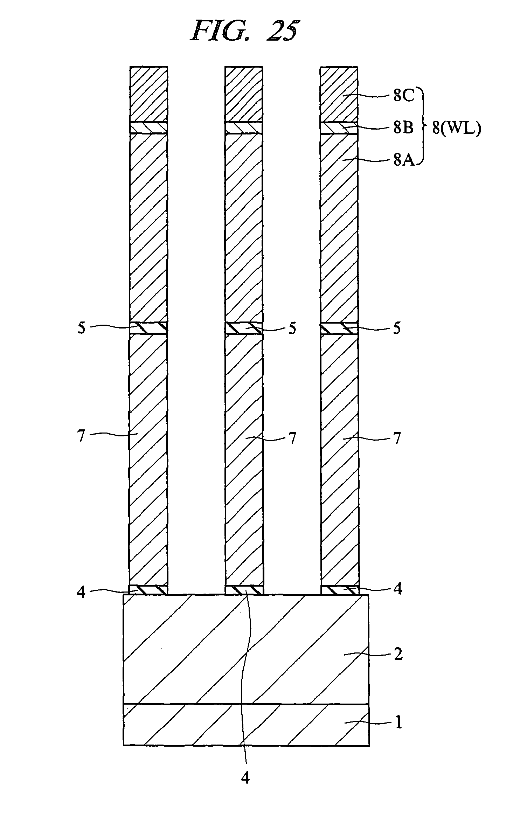

As shown in FIG. 23, the second gate dielectric film 5 is anisotropically etched, thereby exposing the sidewall 7A made of polycrystalline silicon. Thereafter, by etching only silicon selectively by dry etching, the word lines WL are formed with the sidewall 7A between the adjacent word lines WL removed, and the floating gates 7 are formed with the sidewalls 7A right under the respective word line WL left as shown in FIG. 24 and FIG.25. FIG. 24 is a cross-sectional view taken along a line corresponding to the line B-B' of FIG. 1, and FIG. 25 is a cross-sectional view taken along a line corresponding to the line C-C' of FIG. 1.

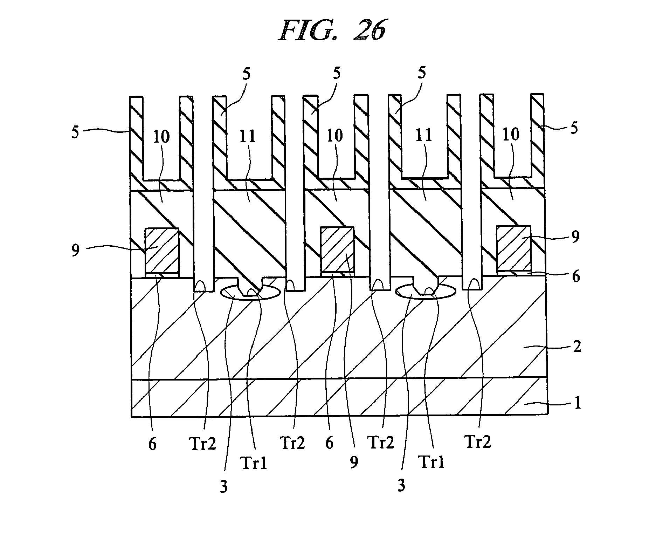

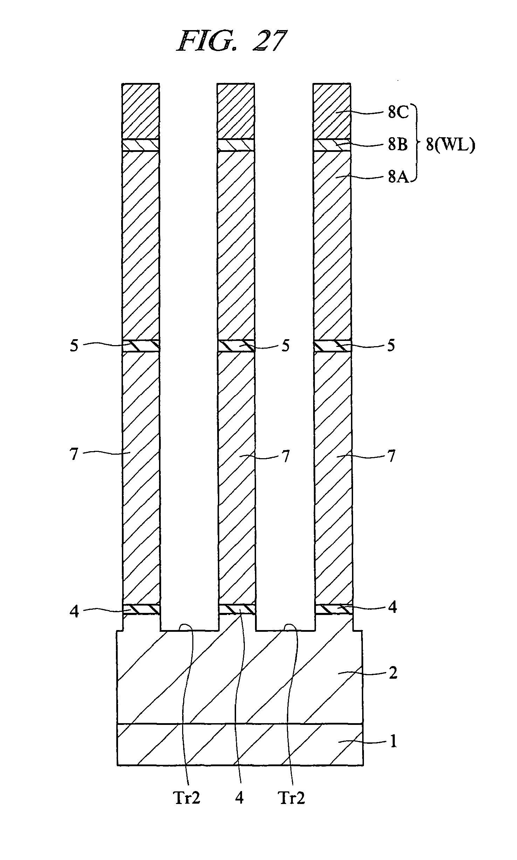

Alternatively, as shown in FIGs. 26 and 27, the first gate dielectric film 4 and part of the p-type well 2 exposed from between the adjacent word lines WL can be etched to form a groove Tr2 in the principal surface of the p-type well 2. By thus performing the etching, an unnecessary leakage current in the principal surface of the p-type well 2 can be reduced. FIG. 26 is a cross-sectional view taken along a line corresponding to the line B-B' of FIG. 1, and FIG. 27 is a cross-sectional view taken along a line corresponding to the line C-C' of FIG. 1.

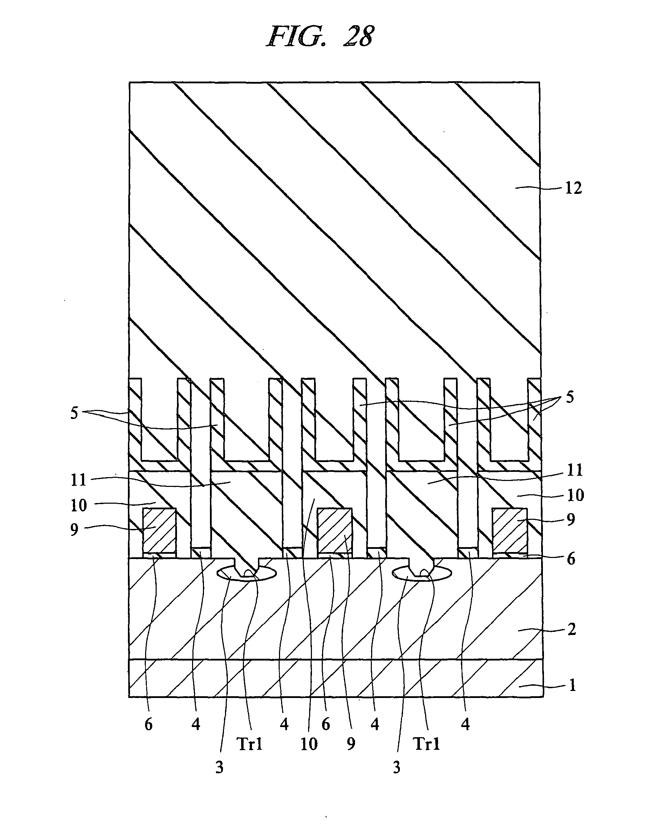

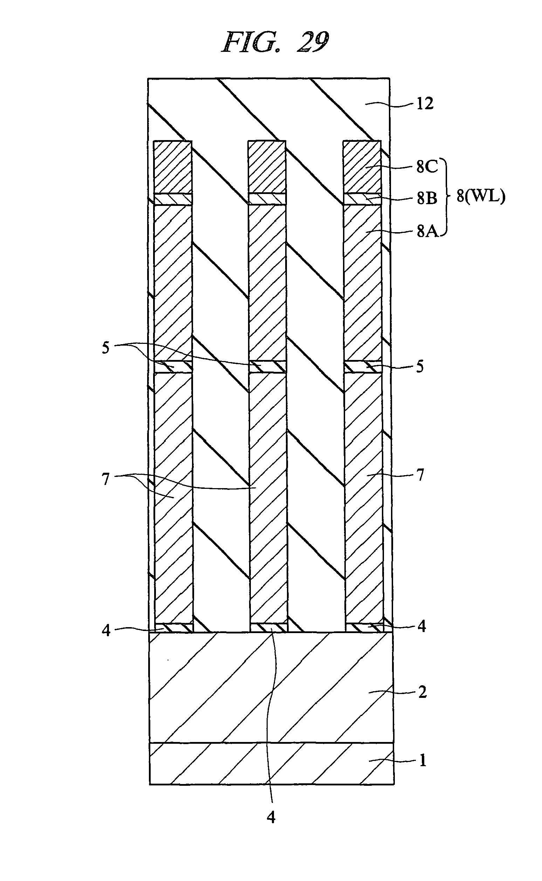

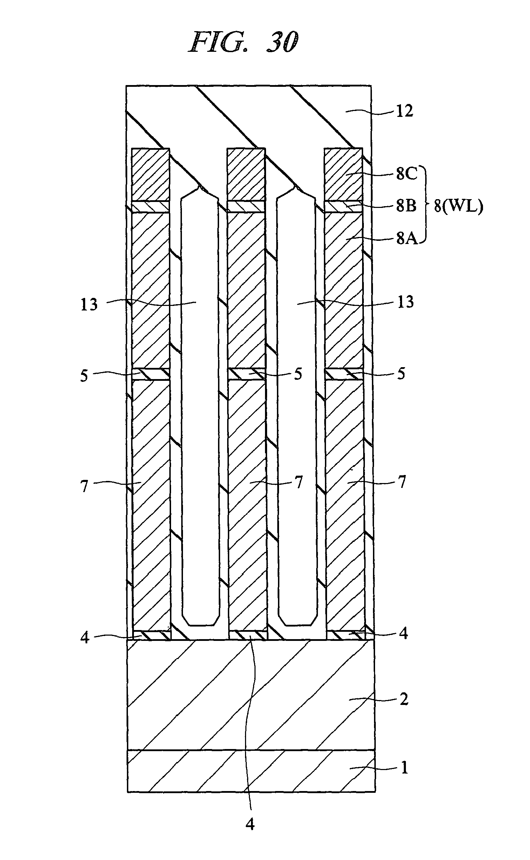

As shown in FIGs. 28 and 29, a silicon dioxide film is deposited by the CVD, a space between the adjacent word lines WL is buried, and the floating gate 7 is insulated from surroundings. At this moment, as shown in FIG. 30, a space 13 can be formed between the floating gates 7 adjacent to each other in the Y direction by tuning the CVD. A dielectric constant of the space 13 is lower than that of silicon dioxide. Due to this, by forming the space 13, an electrostatic interference between the adjacent floating gates 7 can be reduced. FIG. 28 is a cross-sectional view taken along a line corresponding to the line B-B' of FIG. 1, and FIG. 29 and FIG. 30 are cross-sectional view taken along a line corresponding to the line C-C' of FIG. 1.

As a consequence, a memory array structure shown in FIGs. 1 to 6 is completed. Although not shown, an interlayer dielectric film is then deposited on an upper portion of the control gate 8, contact holes to the control gate 8, the p-type well 2, the n-type diffusion layer 3, the auxiliary gate, and the inversion layer are then formed, and a metal film deposited on the interlayer insulating film is patterned, thereby forming wirings. Consequently, the flash memory is nearly completed.

In the first embodiment, by forming the n-type diffusion layer 3 deep in the p-type well 2, an effective offset is formed between the floating gate 7 and the source or drain of the memory cell. Due to this, as compared with an instance in which the groove Tr1 is not provided, a channel length is substantially long and the memory cell transistor exhibits high short-channel-effect tolerance. Because of this advantage, according to the first embodiment, the data line pitch can be narrowed as compared with the instance in which the groove Tr1 is not provided.

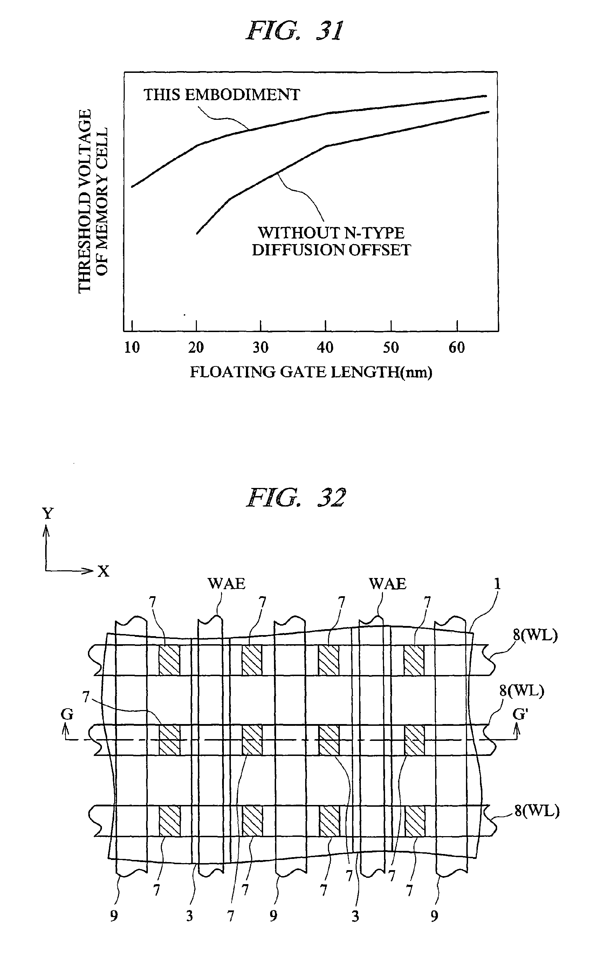

FIG. 31 is a graph showing a comparison between an instance in which the n-type diffusion layer 3 is formed in the p-type well 2 with an offset of only 45 nanometers (first embodiment) and an instance of no offset (no groove Tr1) in the relationship between a gate length of the floating gate 7 and a threshold voltage of the memory cell transistor, i.e., so-called roll-off characteristics. In case of no offset, if the gate length of the floating gate 7 is made smaller, the threshold voltage is suddenly reduced by the short channel effect. Finally, punch-through occurs between the source and the drain, with the result that the memory cell transistor on/off cannot be controlled by the control gate 8. According to the first embodiment, by contrast, because of the high short-channel-effect tolerance, even if the gate length of the floating gate 7 is made smaller, the threshold voltage is reduced only slightly.

Generally, in an MOS transistor in which each of a source and a drain is formed by the n-type diffusion layer, if the both n-type diffusion layers are formed deep in the p-type well, the short-channel-effect tolerance is deteriorated for the following reason. As compared with the instance of forming the n-type diffusion layer on the principal surface of the p-type well, each of the source and the drain is apart from the gate electrodes although the distance between the source and the drain is constant. As a result, a potential of the p-type well 2 cannot be controlled by the gate electrode potential.

In the first embodiment, only one of the source and the drain of the memory cell is formed deep in the p-type well 2, whereby the distance between the source and the drain can be large. Moreover, since one of the source and the drain of the memory cell exists near the gate electrodes (the floating gate 7 and the control gate 8), the gate electrode potential can sufficiently control the potential of the p-type well 2. The short-channel-effect tolerance is thereby improved.

Moreover, in the first embodiment, during the data read operation, the source of the memory cell transistor is formed by the n-type diffusion layer 3 and the drain is formed by the inversion layer. The inversion layer is formed in an area closer to an interface between the p-type well 2 and the gate dielectric film than an ordinary n-type diffusion layer 3. This can facilitate controlling the potential of the p-type well 2 by the potential of the control gate. Therefore, it is possible to realize higher short-channel-effect tolerance than that of the structure in which both of the source and the drain is formed by the n-type diffusion layer 3.

Furthermore, in the first embodiment, the physical distance between the n-type diffusion layer 3 and the floating gate 7 can be increased. Due to this, a probability of movement of electrons from the n-type diffusion layer 3 into the floating gate 7 or from the floating gate 7 into the n-type diffusion layer 3 can be reduced. Therefore, unnecessary increase or decrease in electric charges of the floating gate 7 is suppressed, and stable data read and write operations are realized.

### (Second Embodiment)

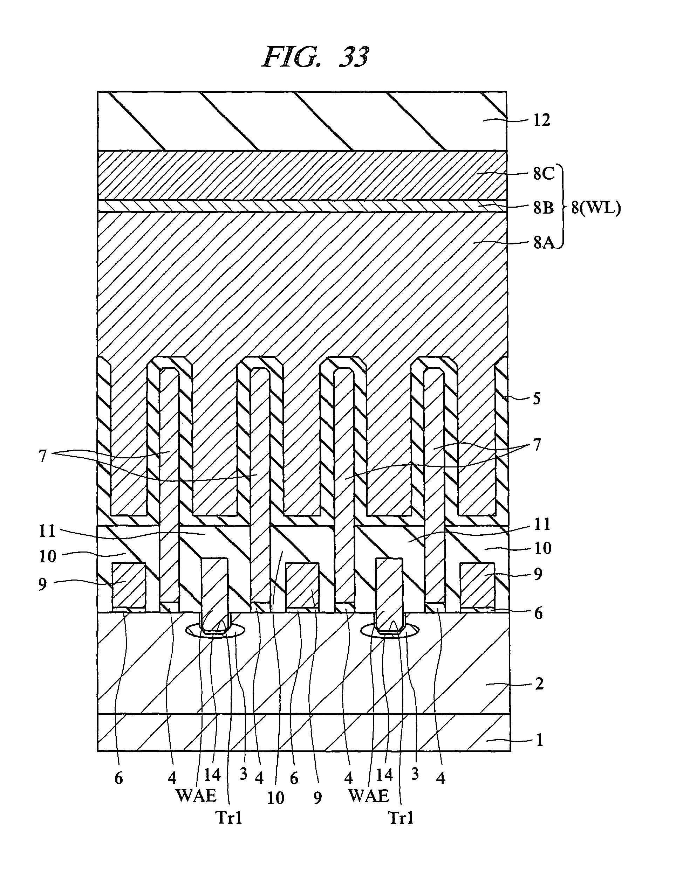

FIG. 32 is a principal part plan view showing a configuration of a memory cell array of a nonvolatile semiconductor memory device according to a second embodiment. FIG. 33 is a principal part cross-sectional view of a semiconductor substrate taken along a line G-G' of FIG. 32. In FIG. 32, some of constituent elements such as a dielectric film are not shown for clarity.

A flash memory that is the nonvolatile semiconductor memory device according to the second embodiment includes a memory array in which a plurality of memory cells are formed in the p-type well 2 on the principal surface of the substrate 1, similarly to the first embodiment. Each of the memory cells includes the n-type diffusion layer 3, the floating gate 7, the control gate 8, the auxiliary gate 9, and a write auxiliary electrode (first electrode) WAE.

The n-type diffusion layer 3 is formed by an n-type region buried in the p-type well 2 and exhibits high short-channel-effect tolerance, similarly to the first embodiment. Differently from the first embodiment, however, the memory cell includes the write auxiliary electrode WAE.

The write auxiliary electrode WAE is formed on the n-type diffusion layer 3 through a silicon dioxide film 14. The write auxiliary electrode WAE is formed in a state of extending along the n-type diffusion layer 3 in the Y direction, and a part (lower part) of the write auxiliary electrode WAE is buried in the groove Tr1. A voltage of the write auxiliary electrode WAE is fixed to reference potential (e.g., a GND potential of 0V). The write auxiliary electrode WAE is insulated from the n-type diffusion layer 3 by the silicon dioxide film 14 formed on an internal surface (a bottom and a sidewall) of the groove Tr1.

The write auxiliary electrode WAE functions to increase a wiring capacitance of the data line. Data is written to the memory cell by discharging the electric charges stored in the wiring capacitance of the data line. Namely, the wiring capacitance of the data line become smaller along with a requirement for reduction in the area of the memory cell. If so, the number of electric charges stored in the data line during one data write operation become smaller. As a result of decrease in the number of electric charges flowing during one data write operation, it is necessary to perform a plurality of data write operations so as to inject a necessary number of electric charges into the floating gate. This means that a speed of writing data to the memory cell is decelerated. In the second embodiment, therefore, the write auxiliary electrode WAE is provided on the n-type diffusion layer 3 through the silicon dioxide film 14, and a capacitance is generated between the n-type diffusion layer 3 and the write auxiliary electrode WAE, thereby realizing the necessary electric charges stored in the data line and accelerating the speed for writing the data to the memory cell. It is thereby possible to realize both the high short-channel effect tolerance and the high data-write speed according to the second embodiment.

Alternatively, a potential of the data line can be adjusted (controlled) by connecting the write auxiliary electrode WAE to a desired power supply circuit and applying a desired potential to the write auxiliary electrode WAE. In an ordinary flash memory without the write auxiliary electrode WAE, it is difficult to supply voltage to a plurality of data lines from an external power supply circuit. In the second embodiment, by contrast, the voltage can be supplied to the data lines through the write auxiliary electrode WAE, so that there is no need to apply voltage to the data lines from an external power supply. This can lessen burden of the external power supply circuit, whereby an area of the external power supply circuit can be reduced and the chip area can be reduced, accordingly. It is to be noted that an operation for supplying the voltage to the write auxiliary electrode WAE is activated in response to the same signal as a Y selection signal.

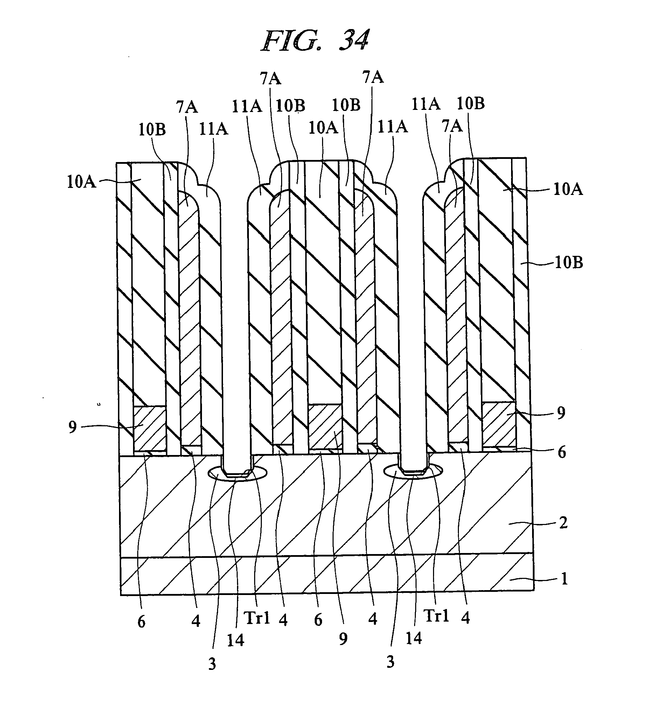

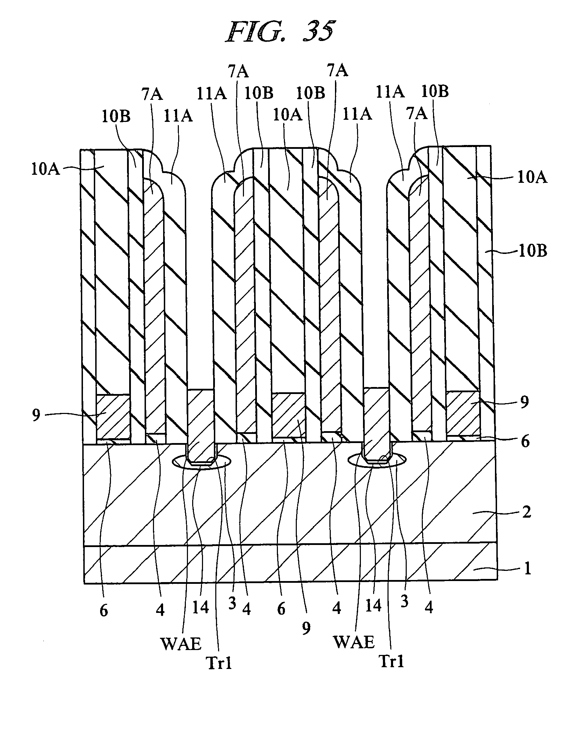

A method of manufacturing the flash memory according to the second embodiment will be described with reference to FIGs. 34 and 35. FIGs. 34 and 35 are cross-sectional views of the substrate 1 taken along a line corresponding to the line B-B' of FIG. 1.

After the same steps as those according to the first embodiment described with reference to FIGs. 9 to 17, the silicon dioxide film 14 is formed on surfaces of the p-type well 2 and the n-type diffusion layer 3 by thermal oxidation. As shown in FIG. 35, an n-type polycrystalline silicon film is deposited by the CVD and polished by the CMP, and an upper portion of the n-type polycrystalline silicon is anisotropically etched while leaving a lower portion thereof, thereby forming the auxiliary write gate WAE. A silicon dioxide film is then deposited by the CVD and polished by the CMP. Thereafter, the same steps as the first embodiment shown in FIG. 18 and the subsequent drawing are executed, thereby nearly completing the flash memory shown in FIGs. 32 and 33.

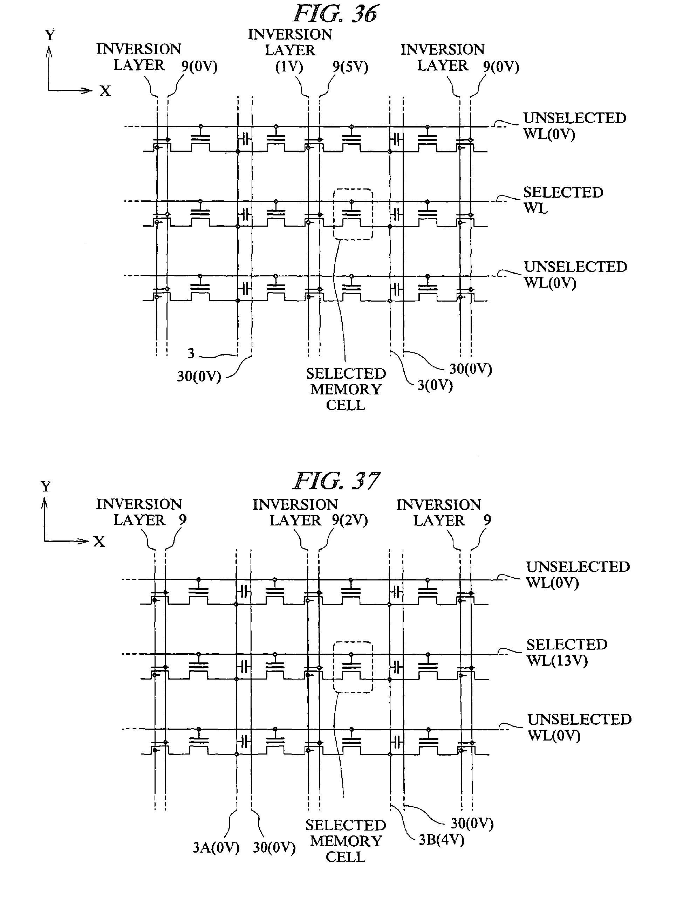

Operations performed by the flash memory according to the second embodiment will be described with reference to equivalent circuits shown in FIGs. 36 to 39. The auxiliary write gate WAE appears on the equivalent circuit in a state of being capacitively coupled to the n-type diffusion layer 3.

During a data read operation, as shown in FIG. 36, a voltage of 0V is applied to the auxiliary write gate WAE adjacent to a selected memory cell. Furthermore, a voltage of about 5V is applied to the auxiliary gate 9 adjacent to the selected memory cell, the inversion layer is formed in the lower portion of the auxiliary gate 9, and the inversion layer is used as the drain. The drain is precharged with a voltage of about 1V. The n-type diffusion layer 3 adjacent to the selected memory cell is used as the source. A voltage of either 0V or negative voltage such as about -2V is applied to non-selected word lines WL (non-selected control gate 8). Finally, a voltage pulse is applied to the selected word line WL (selected control gate 8) corresponding to the selected memory cell. If a threshold voltage of the memory cell transistor is equal to or lower than the voltage pulse applied to the control gate 8, then a large current flows and the voltage of the drain formed by the inversion layer is reduced. If the threshold voltage of the memory cell transistor is equal to or higher than the voltage applied to the control gate 8, no current flows, and the voltage of the drain is kept almost unchanged. By reading this voltage change, the threshold voltage of the memory cell is determined.

During a data write operation, two n-type diffusion layers 3 are used similarly to the first embodiment. As shown in FIG. 37, voltages of the write auxiliary electrode WAE near the selected memory cell, the p-type well 2, and the source-side n-type diffusion layer 3A are kept to 0V. A voltage of about 13V is applied to the selected word line WL (selected control gate 8) corresponding to the selected memory cell. Moreover, the drain-side n-type diffusion layer 3B is precharged with the voltage of about 4V, separated from the external power supply circuit, and turns into an electrically floating state. Thereafter, a pulse of about 2V is applied to the auxiliary gate 9 near the selected memory cell. A channel is thereby formed in the p-type well 2 in the lower portion of the auxiliary gate 9, electrons are discharged from the source, accelerated by the electric field in the source-side end of the channel formed in the p-type well 2 opposed to the floating gate 7 of the selected memory cell, changed into hot electrons, and injected into the floating gate 7 of the selected memory cell. The data write operation is finished when electro-static capacitance of the drain-side n-type diffusion layer 3B in the electrically floating state is charged with the discharged electrons.

As stated, if the data line pitch is narrowed, then an area of a junction formed between the n-type diffusion layer 3B and the p-type well 2 is reduced, and the electro-static capacitance of the junction is reduced. Most of the electrostatic capacitance of the n-type diffusion layer 3B is generated by that of the junction. Due to this, if the data line pitch is narrowed, the quantity of electrons that can be discharged from the n-type diffusion layer 3A serving as the source into the n-type diffusion layer 3B serving as the drain in the floating state per data write operation decreases. Namely, the number of electrons that can be injected into the floating gate 7 during one data write operation decreases, which causes deceleration of the write speed.

In the second embodiment, the write auxiliary electrode WAE exists on the n-type diffusion layer 3B. An electro-static capacitance is additionally generated by electro-static coupling between the n-type diffusion layer 3B and the write auxiliary electrode WAE. Due to this, even if the data line pitch is narrowed and the coupling capacitance between the n-type diffusion layer 3B and the p-type well 2 is reduced, it is possible to discharge a sufficient number of electrons per data write operation by the electro-static capacitance between the n-type diffusion layer 3B and the write auxiliary electrode WAE. Accordingly, it is possible to perform the high speed data write operation.

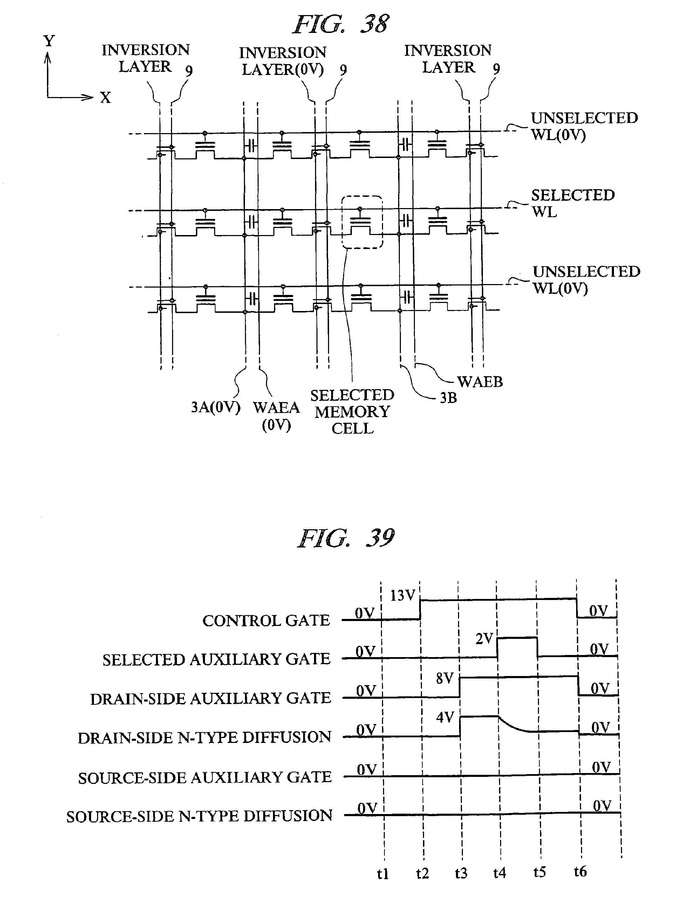

In the data write operation stated above, 0V is applied to the write auxiliary electrode WAE. Alternatively, a potential can be positively applied. It will be next described with reference to FIGs. 38 and 39. FIG. 38 is equivalent circuit diagram of principal parts of a memory circuit in the flash memory according to the second embodiment. FIG. 39 is a waveform view showing an example of waveforms of voltages applied to the respective electrodes.

As shown in FIG. 38, for example, voltages of the p-type well 2, the source-side n-type diffusion layer 3A, and the source-side write auxiliary electrode WAEA are held at 0V. Next, a voltage of 0V is applied to the drain-side write auxiliary electrode WAEB. After a voltage of 0V is charged on the drain-side n-type diffusion layer 3B at time t1 (see FIG. 39), the drain-side n-type diffusion layer 3B is electrically disconnected from the external power supply and turned into a floating state. Next, at time t2 (see FIG. 39), a voltage of about 13V is applied to the word line WL (control gate 8) corresponding to the selected memory cell. Next, at time t3 (see FIG. 39), the voltage of the drain-side write auxiliary electrode WAEB is raised to about 8V. At this moment, the voltage of the electrically insulated, drain-side n-type diffusion layer 3B is raised to about 4V by the electro-static capacitive coupling between the drain-side n-type diffusion layer 3B and the drain-side write auxiliary electrode WAEB. Then, at time t4 (see FIG. 39), a pulse of about 2V is applied to the auxiliary gate 9 near the selected memory cell. A channel is thereby formed in the p-type well 2 in the lower portion of the auxiliary gate 9, electrons are discharged from the source, the electrons are accelerated by the electric field on the end of the floating gate 7 to be turned into hot electrons, and the hot electrons are injected into the floating gate 7 of the selected memory cell. This data write operation is finished when the electro-static capacitance of the drain-side n-type diffusion layer 3B in the electrically floating gate is charged with the discharged electrons.

With the method according to the second embodiment, there is no need to apply voltage to the drain-side n-type diffusion layer 3B from the external power supply. It is thereby possible to lessen the burden of the external power supply circuit and reduce the chip area.

### (Third Embodiment)

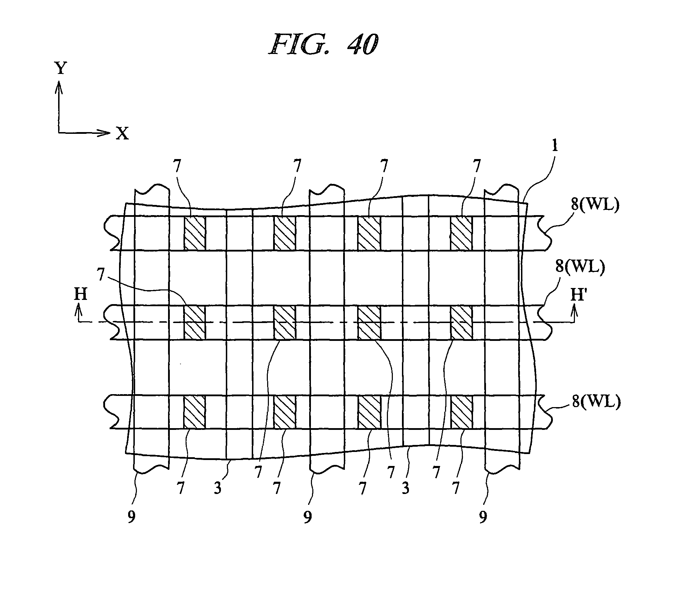

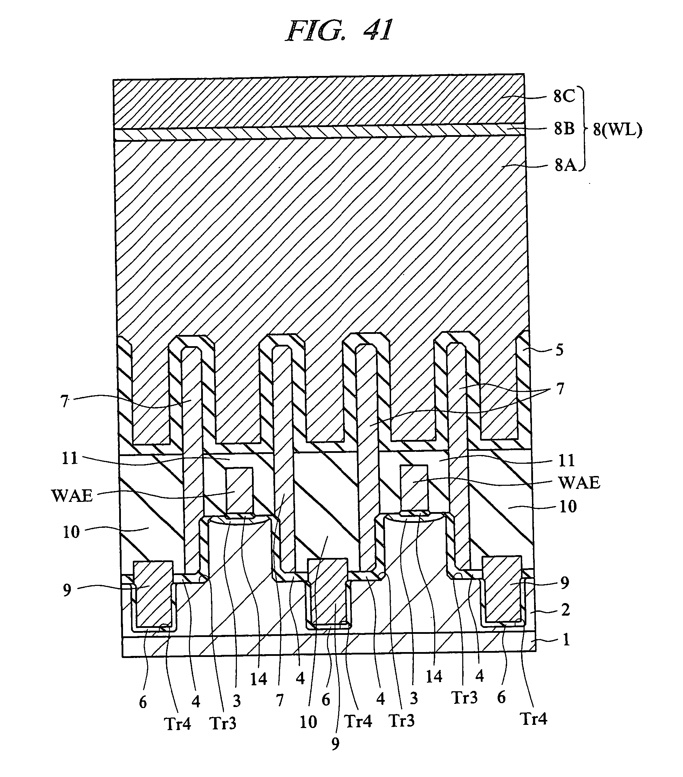

FIG. 40 is a principal-part plan view showing a configuration of a memory array of a nonvolatile semiconductor memory device according to a third embodiment of the present invention. FIG. 41 is a principal-part cross-sectional view taken along a line H-H' of FIG. 40. In FIG. 40, some of constituent elements such as a dielectric film are not shown for clarity.

A flash memory that is the nonvolatile semiconductor memory device according to the third embodiment includes a memory array in which a plurality of memory cells are formed in the p-type well 2 on the principal surface of the substrate 1, similarly to the first embodiment. Each of the memory cells includes the n-type diffusion layer 3, the floating gate (first gate electrode) 7, the control gate (second gate electrode) 8, the auxiliary gate (third gate electrode) 9, and the write auxiliary electrode WAE. The write auxiliary electrode WAE is formed on the n-type diffusion layer 3 through the silicon dioxide film 14.

The third embodiment is characterized in that bottoms of the floating gate electrode 7, the auxiliary gate electrode 9, and the write auxiliary electrode WAE are not present in the same plane. The third embodiment is also characterized in that the principal surface of the p-type well 2 is processed into staircase pattern. The third embodiment is further characterized in that an interface between the first gate dielectric film 4 and the p-type well 2 and an interface between the third gate dielectric film 6 and the p-type well 2, which are channels through which electrons are conducted, are not linear but bent.

The auxiliary gate 9, which is made of, for example, an n-type polycrystalline silicon film, is formed to be buried in the p-type well 2 through the third gate dielectric film 6. Namely, a groove Tr3 is formed between the write auxiliary electrodes WAE adjacent to each other on the principal surface of the substrate 1, a groove Tr4 smaller in width than the groove Tr3 is formed on a bottom of the groove Tr3, and the auxiliary gate 9 is provided in the groove Tr3, and, a part of the auxiliary gate 9 is buried in the groove Tr3. The auxiliary gate 9 is insulated from the p-type well 2 by the third gate dielectric film 6 formed on an internal surface (a bottom and a sidewall) of the groove Tr4.

The floating gate 7, which is made of an n-type polycrystalline silicon film, is formed so that two surfaces thereof contact with the p-type well 2 through the first gate dielectric film 4. Namely, a bottom of the floating gate 7 is opposed to the bottom of the grove Tr3 through the first gate dielectric film 4, and a part of a side wall of the floating gate 7 is opposed to that of the groove Tr3 through the first gate dielectric film 4. In this configuration, during a data read operation, electrons flow from the n-type diffusion layer 3 opposed to the write auxiliary electrode WAE adjacent to the auxiliary gate 9 toward the inversion layer formed in the p-type well 2 opposed to the auxiliary gate 9.

During a data write operation, electrons flow from the n-type diffusion layer 3 opposed to the write auxiliary electrode WAE toward the n-type diffusion layer opposed to the write auxiliary electrode WAE adjacent thereto.

Alternatively, the auxiliary gate 9 and the write auxiliary electrode WAE can be arranged oppositely and the inversion layer and the n-type diffusion layer 3 can be arranged oppositely. Namely, the n-type diffusion layer 3 can be arranged on the bottom side of the groove Tr4, and the inversion layer can be arranged on an upper surface of a convex portion of the p-type well 2. With this alternative arrangement, however, the n-type diffusion layer 3 is provided deep in the p-type well 3 as compared with the instance in which the inversion layer is arranged on the bottom of the groove Tr4, thereby making it difficult to control the potential of the p-type well 2. As a result, during the data write operation, when electric charges flow between the adjacent n-type diffusion layers 3, the electric charges may possibly flow not to the surface of the p-type well 2 opposed to the floating gate 7 but deep in the substrate 1, i.e., punch-through may possibly occur. On the other hand, if the inversion layer is arranged on the bottom side of the groove Tr4 and the n-type diffusion layer 3 is arranged on the upper surface of the convex portion of the p-type well 2, the potential of the p-type well 2 opposed to the floating gate 7 and the auxiliary gate 9 between the adjacent n-type diffusion layers 3 can be sufficiently controlled. Due to this, punch-through hardly occurs. It is, therefore, preferable to arrange the inversion layer on the bottom side of the groove Tr4 and the n-type diffusion layer 3 on the upper surface of the convex portion of the p-type well 2.

According to a result of a simulation made by the inventors of the present invention, data write efficiency can be enhanced with the configuration shown in FIG. 41 for the following reasons. With the configuration shown in FIG. 41, during the data write operation, the electrons contributing to storage of data can be easily injected from the bottom side of the floating gate 7 into the floating gate 7 because of arrangement of the bottom of the floating gate 7 to be opposed to the current flow along the sidewall of the auxiliary gate 9 (groove Tr4).

An equivalent circuit of the flash memory according to the third embodiment is identical to that according to the second embodiment. Operations are identical, accordingly.

According to the third embodiment, it is possible to realize both the high short-channel-effect tolerance and the high speed data write operation.

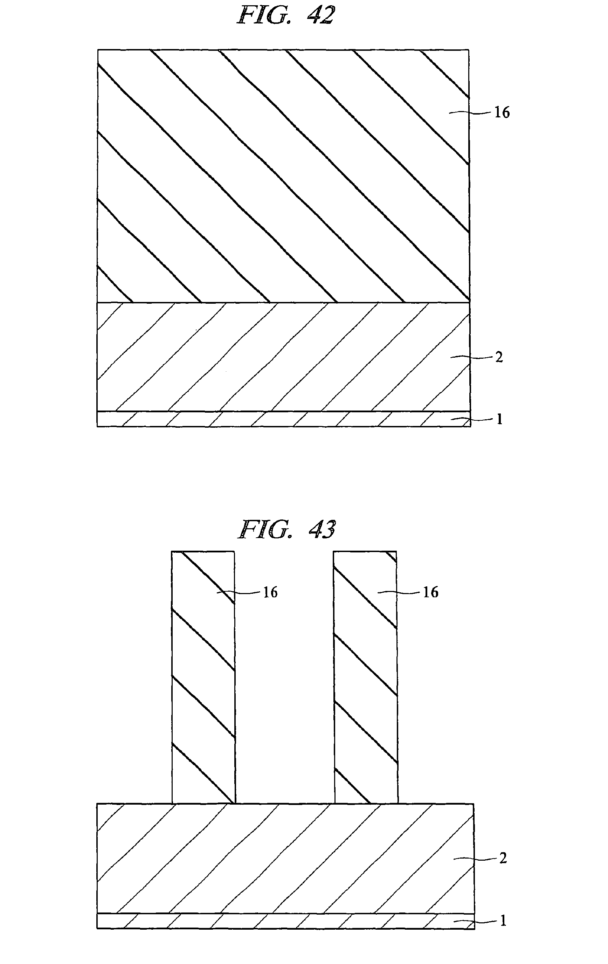

A method of manufacturing the flash memory according to the third embodiment will be described with reference to FIGs. 42 to 60 in order of steps. It is to be noted that FIGs. 42 to 60 are cross-sectional views each taken along a line corresponding to the line H-H' of FIG. 40 unless specified otherwise.

First, as shown in FIG. 42, impurity ions are implanted into the substrate 1 (which is the semiconductor wafer at this stage) made of p-type single crystalline silicon, thereby forming the p-type well 2. Thereafter, a silicon dioxide film 16 is deposited on the principal surface of the substrate 1 by the CVD.

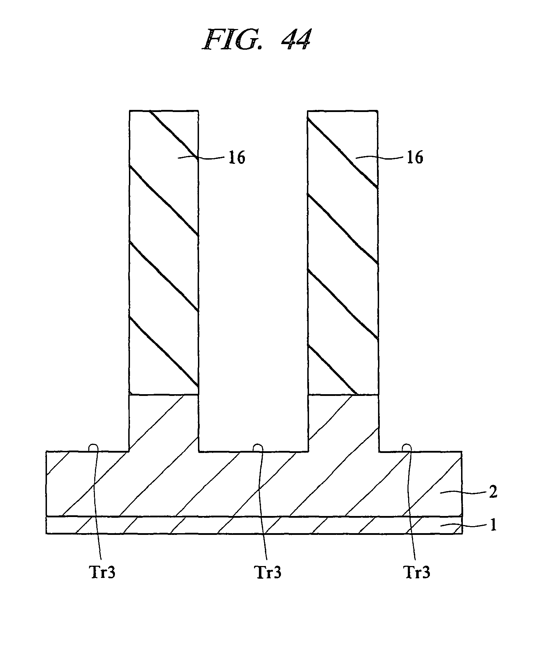

As shown in FIG. 43, the silicon dioxide film 16 is processed into stripes by photolithography. As shown in FIG. 44, the substrate 1 is etched using the silicon dioxide film 16 processed into stripes as a mask, thereby forming the groove Tr3 on the principal surface of the p-type well 2.

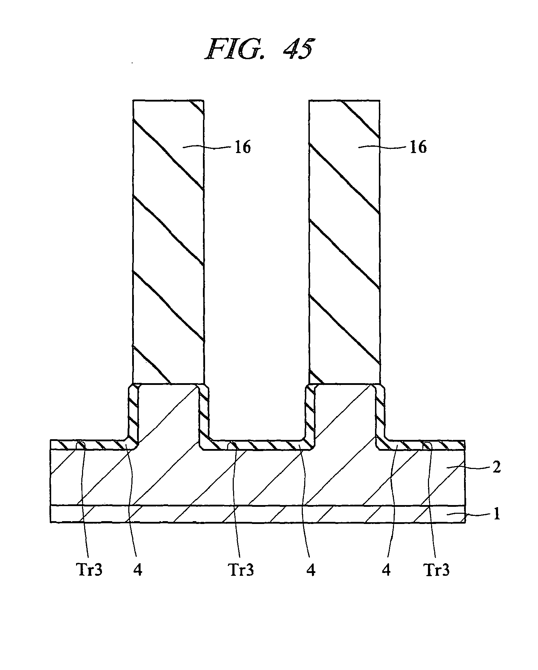

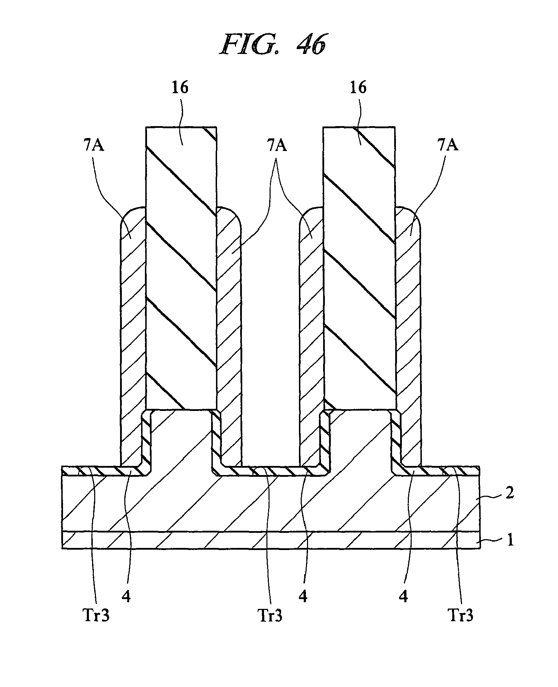

As shown in FIG. 45, the substrate 1 is thermally oxidized, thereby forming the first gate dielectric film 4 on the principal surface of the p-type well 2 exposed from the pattern of dioxide silicon film 16, i.e., on the bottom and the side of the groove Tr3. As shown in FIG. 46, an n-type polycrystalline silicon film is deposited by the CVD or the like and etched back by anisotropic etching, thereby forming the sidewall 7A made of the n-type polycrystalline silicon film along the pattern of the silicon dioxide film 16 and side walls of the groove Tr3. At this moment, conditions of the anisotropic etching are adjusted so that side walls of the sidewall 7A are orthogonal to the principal surface of the substrate 1.

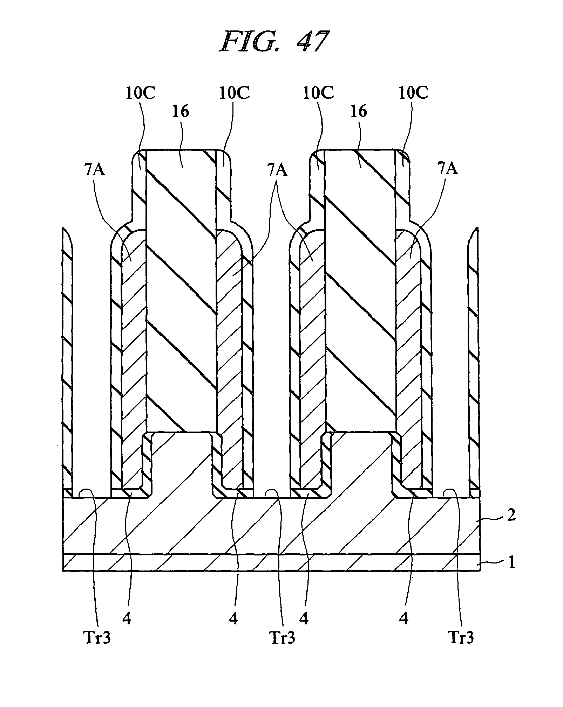

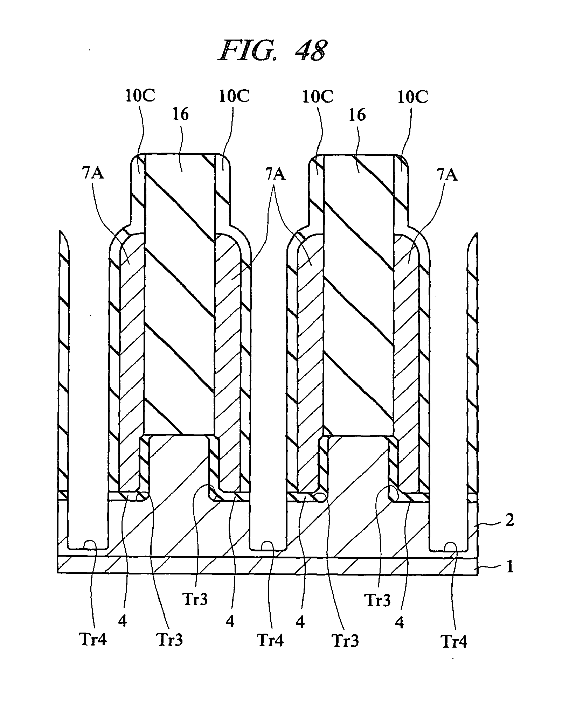

As shown in FIG. 47, a silicon dioxide film is deposited by the CVD or the like and etched back by anisotropic etching, thereby forming a sidewall 10C made of the silicon dioxide film along the pattern of the silicon dioxide film 16 and side walls of the sidewall 7A. As shown in FIG. 48, the silicon of the substrate 1 exposed from the sidewall 10C is removed by anisotropic etching using the sidewall 10C as a mask, thereby forming the groove Tr4 on the bottom of the groove Tr3.

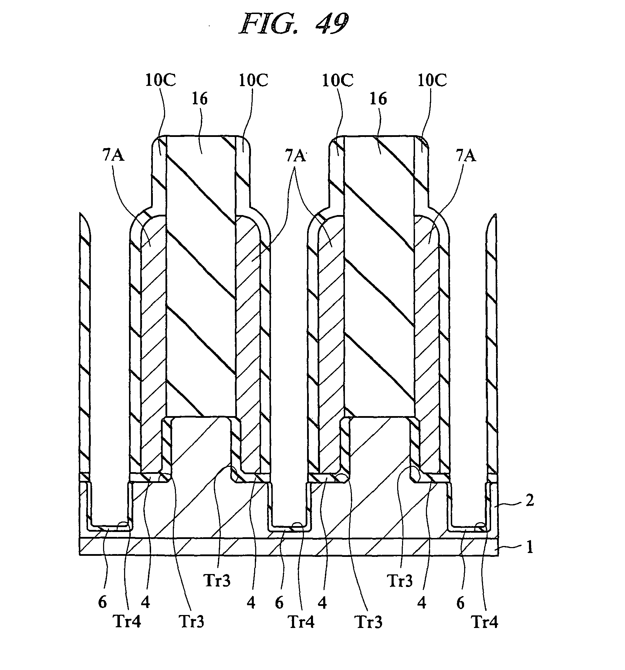

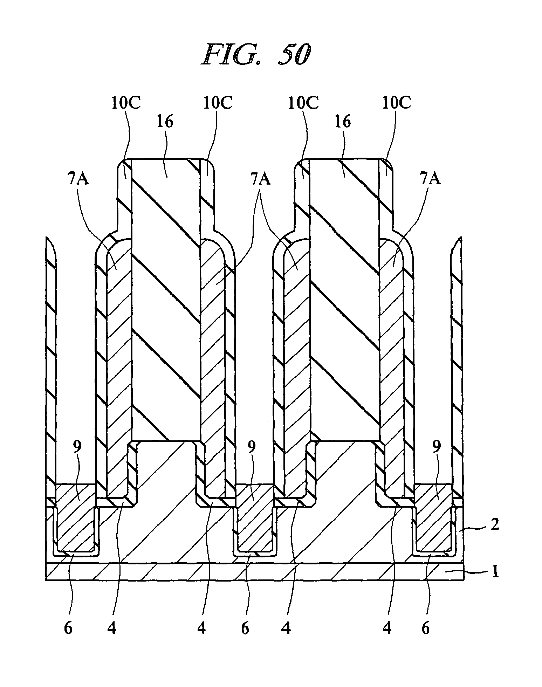

As shown in FIG. 49, the substrate 1 is thermally oxidized, thereby forming the third gate dielectric film 6 on the inner surface (bottom and sidewall) of the groove Tr4. As shown in FIG. 50, n-type polycrystalline silicon film is deposited on the principal surface of the substrate 1 by the CVD or the like and polished and flattened by the CMP or the like. Thereafter, the n-type polycrystalline silicon is etched by anisotropic etching, thereby forming the auxiliary gate electrode 9 between patterns of the adjacent silicon dioxide films 16. A part of the auxiliary gate 9 is buried in the groove Tr4.

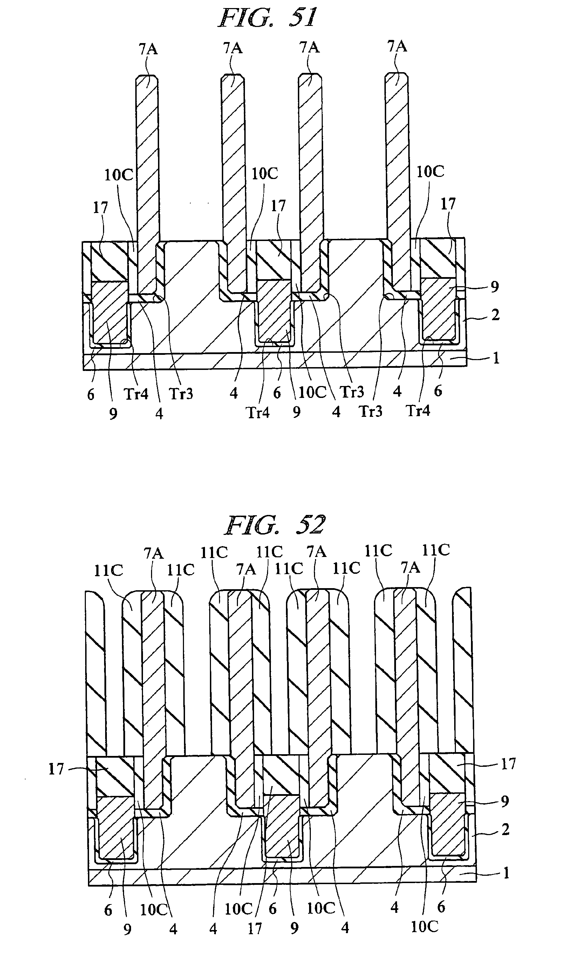

As shown in FIG. 51, a silicon dioxide film 17 is deposited on the principal surface of the substrate 1 by the CVD or the like and polished and flattened by the CMP or the like. Thereafter, the silicon dioxide film 17 is removed by anisotropic etching. This etching is finished when the p-type well 2 is exposed. As shown in FIG. 52, a silicon dioxide film is deposited on the principal surface of the substrate 1 by the CVD or the like and anisotropically etched, thereby forming a sidewall 11C made of the silicon dioxide film on a side wall of the sidewall 7A.

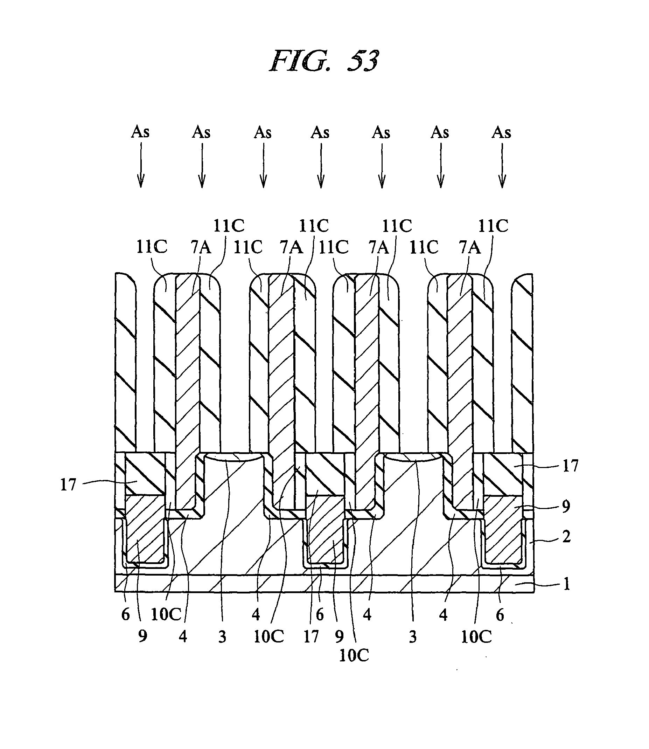

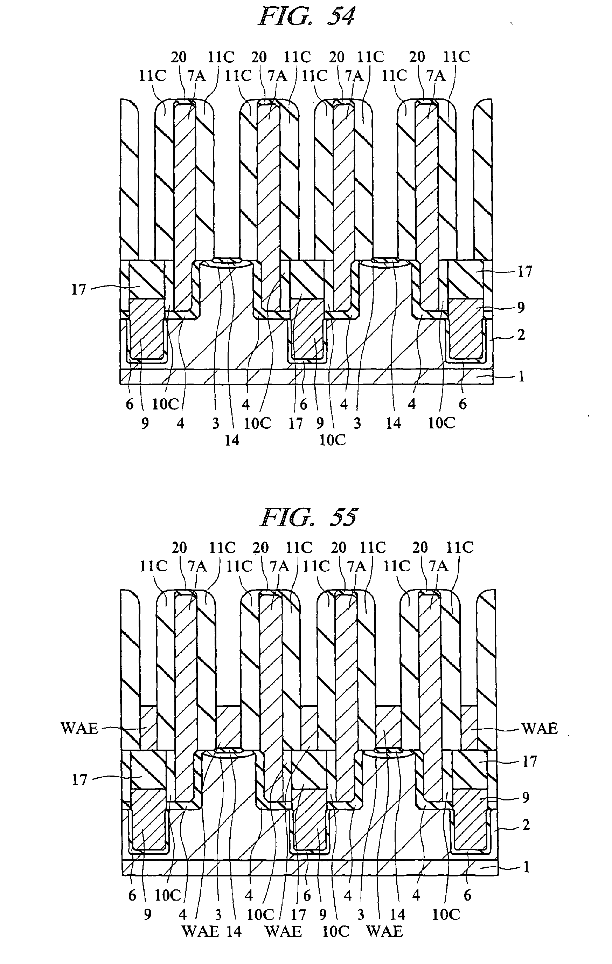

As shown in FIG. 53, impurity ions of, for example, arsenic (As) ions are implanted into the entire principal surface of the substrate 1 using the sidewall 11C as a mask, and appropriate heat treatment is performed, thereby forming the n-type diffusion layer 3 in a region implanted with the impurities in the p-type well 2. As shown in FIG. 54, the substrate 1 is thermally oxidized, thereby forming the silicon dioxide film 14 on the n-type diffusion layer 3 and a silicon dioxide film 20 in an upper portion of the sidewall 7A made of the polycrystalline silicon.

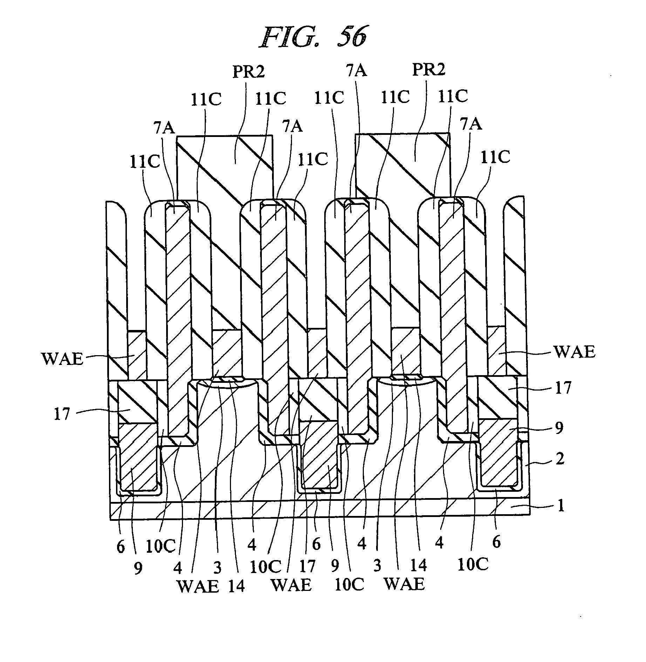

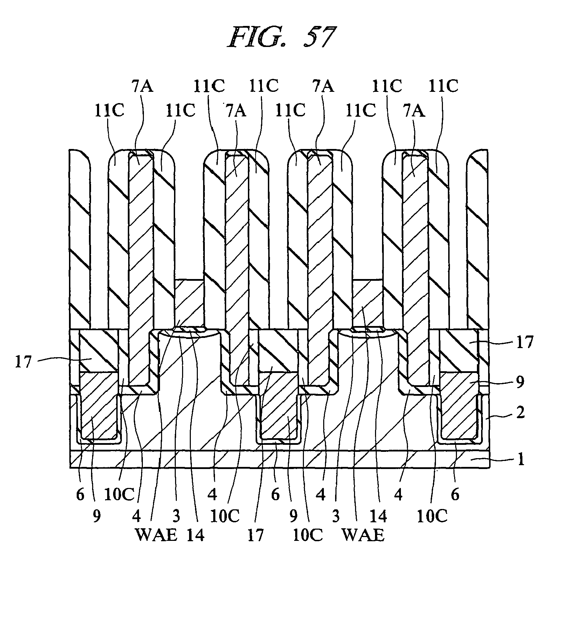

As shown in FIG. 55, an n-type polycrystalline silicon film is deposited on the principal surface of the substrate 1 by the CVD or the like, flattened by the CMP or the like, and anisotropically etched, thereby forming the write auxiliary electrode WAE. As shown in FIG. 56, a photoresist PR2 is processed into stripes by photolithography. The photoresist PR2 is in a pattern in which the write auxiliary electrode WAE located between the adjacent auxiliary gates 9 is covered with the photoresist PR2 and in which the write auxiliary electrode WAE located right on the auxiliary gate 9 is exposed. Using the photoresist PR2 as a mask, the write auxiliary electrode WAE right on the auxiliary gate 9 is removed by anisotropic etching. Thereafter, the photoresist PR2 is removed, whereby the write auxiliary electrodes WAE are provided between the adjacent auxiliary gates 9 as shown in FIG. 57.

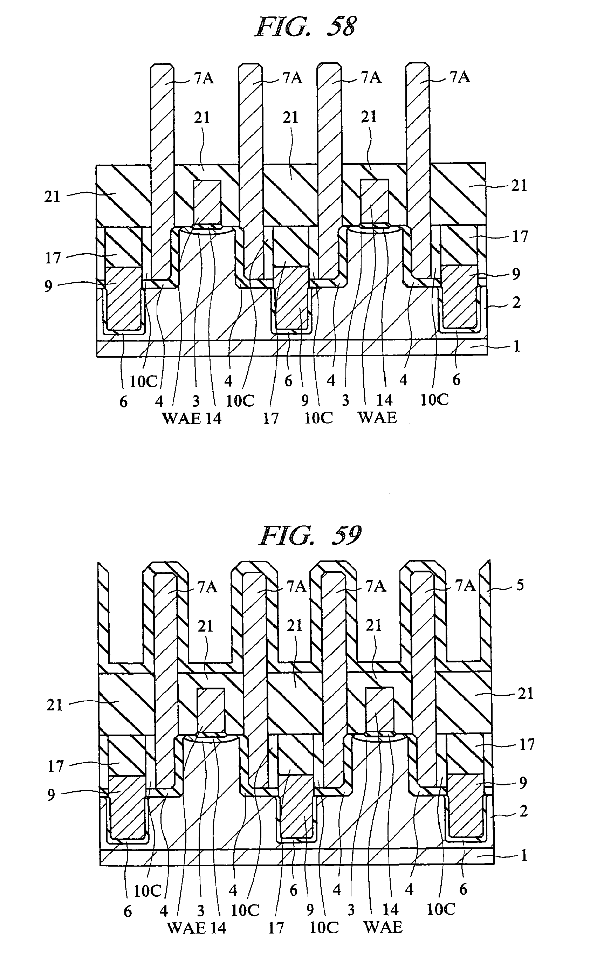

As shown in FIG. 58, a silicon dioxide film 21 is deposited by the CVD, flattened by the CMP, and anisotropically etched, thereby exposing an upper surface of the sidewall 7A. As shown in FIG. 59, a silicon dioxide film, a silicon nitride film, and a silicon dioxide film are sequentially deposited by the CVD, thereby the second gate dielectric film 5 is formed. The exposed surface of the sidewall 7A is covered with the second gate dielectric film 5.

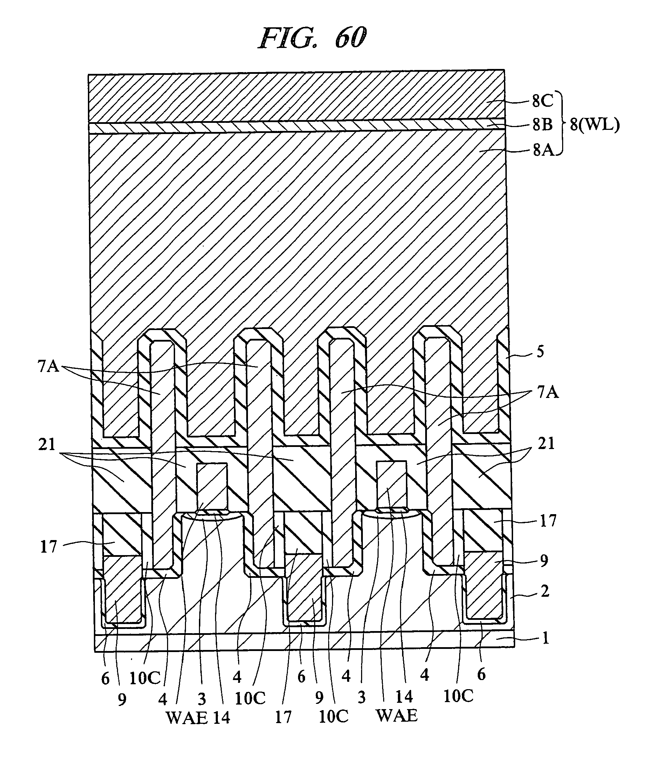

As shown in FIG. 60, the n-type polycrystalline silicon film 8A, the tungsten nitride 8B, and the tungsten film 8C are sequentially deposited by the CVD and the sputtering. Thereafter, using a photoresist film as a mask, the tungsten film 8C, the tungsten nitride film 8B, the n-type polycrystalline silicon film 8A, and the second gate dielectric film 5 are patterned by anisotropic etching. Similarly to the first and second embodiments, the sidewall 7A is patterned, whereby an array structure of the flash memory shown in FIGS. 40 and 41 is completed.

According to the third embodiment, not only the upper surface of the p-type well 2 but also side surfaces of the p-type well 2 can be used as the channel through which electrons are conducted. It is thereby possible to set channel lengths of the floating gate 7 and the auxiliary gate 9 longer than those processed by photolithography and dry etching. In other words, even if the data line pitch is narrowed, the length of the side surface of the p-type well 2 that can be used as the channel is substantially unchanged. Accordingly, the effective channel length electrically adjustable by the floating gate 7 and the auxiliary gate 9 is not reduced and the operation limit by the short channel effect can be avoided.

### (Fourth Embodiment)

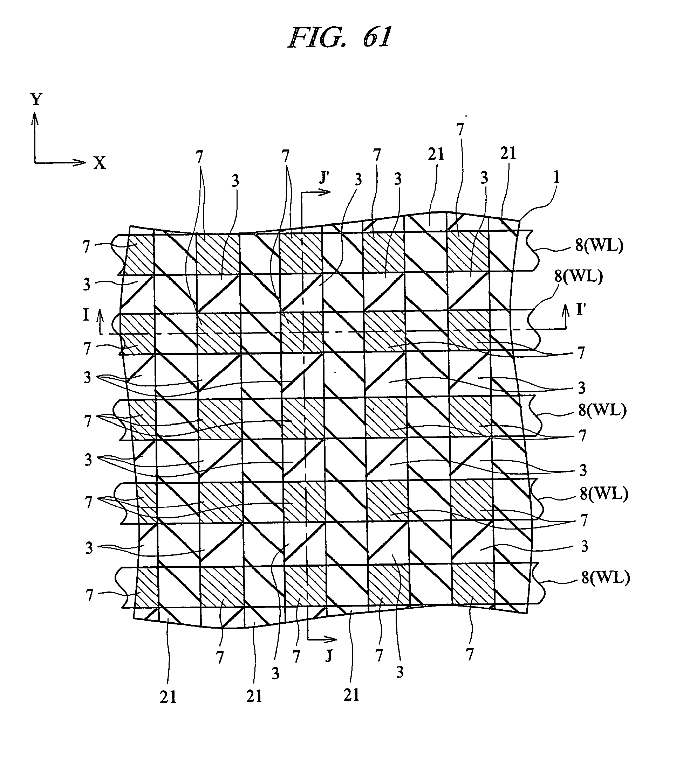

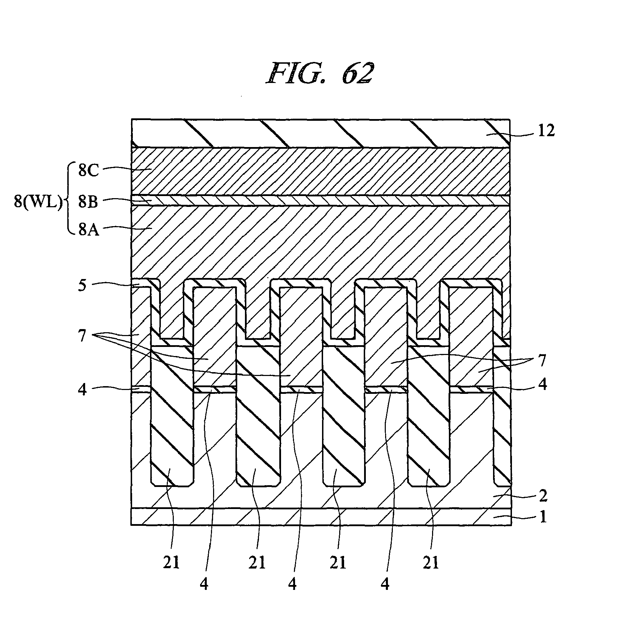

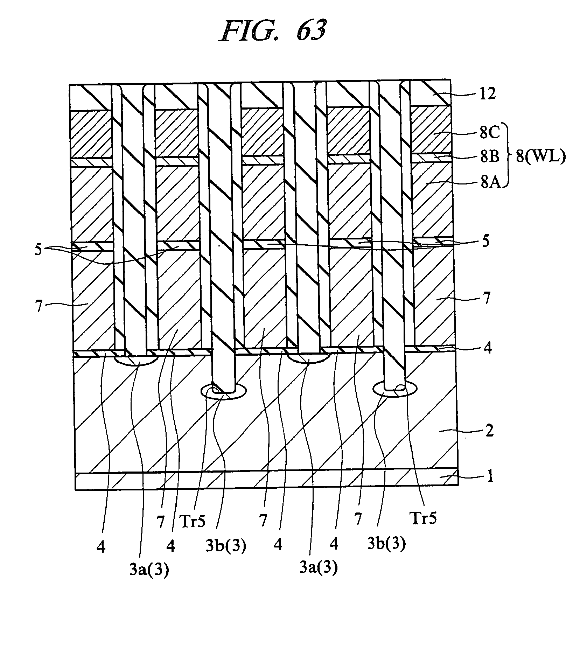

FIG. 61 is a principal part plan view showing a configuration of a memory array of a nonvolatile semiconductor memory device according to a fourth embodiment of the present invention. FIG. 62 is a principal part cross-sectional view taken along a line I-I' of FIG. 61. FIG. 63 is a principal part cross-sectional view taken along a line J-J' of FIG. 61. In FIG. 61 (plan view), some of constituent elements such as a dielectric film are not shown for clarity.

The nonvolatile semiconductor memory device according to the fourth embodiment is a so-called NAND flash memory. The nonvolatile semiconductor memory device includes a memory array in which a plurality of memory cells are formed on the p-type well 2 on the principal surface of the substrate 1. In the fourth embodiment, differently from the first to third embodiments, the memory cells are connected in series. Each of the memory cells includes the n-type diffusion layer 3, the floating gate 7, and the control gate 8.

The control gates 8 of the respective memory cells are connected in the row direction (X direction), thereby forming the word line WL. The floating gate 7 is insulated from the substrate 1 by the first gate dielectric film 4. The floating gate 7 is insulated from the control gate 8 by the second gate dielectric film 5.

The memory cells are connected in series in the column direction (Y direction) on the p-type well 2 isolated by isolation regions (isolation units) 21. Namely, a plurality of memory cells arranged in the Y direction are connected in series through the n-type diffusion layer 3.

The fourth embodiment is greatly characterized in that adjacent n-type diffusion layers 3a and 3b differ in height (height in a thickness or depth direction of the substrate 1). From viewpoints of each memory cell, the source-side n-type diffusion layer 3a differs in height from the drain-side n-type diffusion layer 3b, and n-type diffusion layers in one of source-side and drain-side adjacent to each other is formed at position relatively deep in the p-type well 2 of the substrate 1. That is, one n-type diffusion layer 3a is formed on the principal surface of the substrate 1 and the other n-type diffusion layer 3b is formed at the position apart from the principal surface of the substrate 1 in the depth (thickness) direction of the substrate 1. In this embodiment, the other n-type diffusion layer 3b is formed on a bottom side of a groove Tr5 formed on the principal surface of the substrate 1.

By so configuring, offset is formed between n-type diffusion layer 3 and the floating gate. Therefore, similarly to the first embodiment, it is possible to effectively increase the channel length and obtain the high short-channel-effect tolerance. According to the fourth embodiment, therefore, it is possible to obtain the high short-channel-effect tolerance and reduce cost by downsizing the memory cell.

Operations performed by the flash memory according to the fourth embodiment will be described.

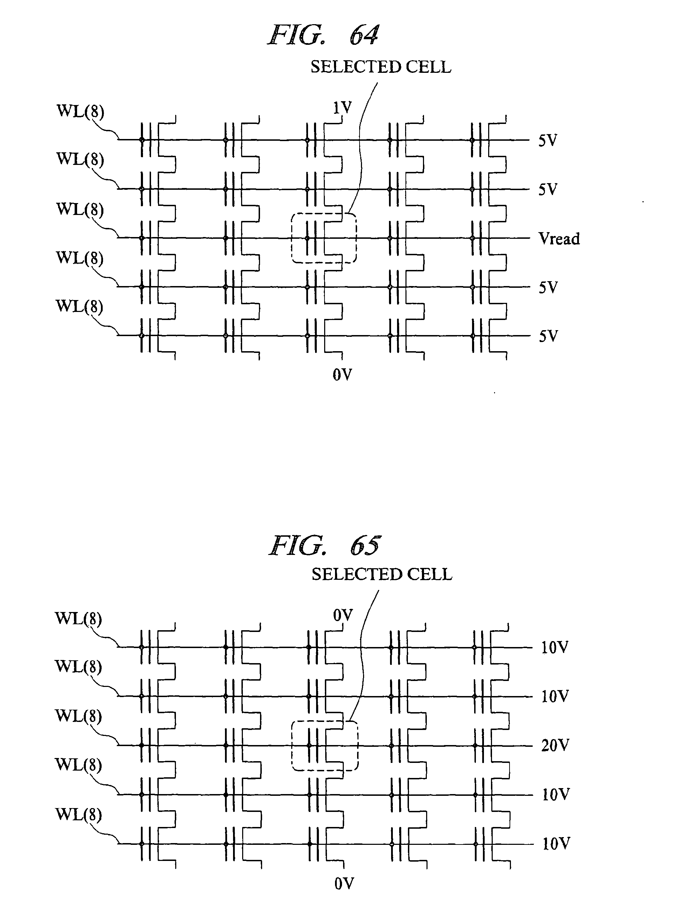

FIG. 64 shows voltages during a data read operation. During the data read operation, a voltage of 1V is applied to one end of a memory cell column including a selected memory cell, a voltage of 0V is applied to the other end thereof, and a voltage of 0V is applied to the p-type well 2. Furthermore, a read determination voltage Vread is applied to the selected word line WL so as to determine whether the selected memory cell is turned on or off. A voltage of about 5V is applied to non-selected word lines WL.

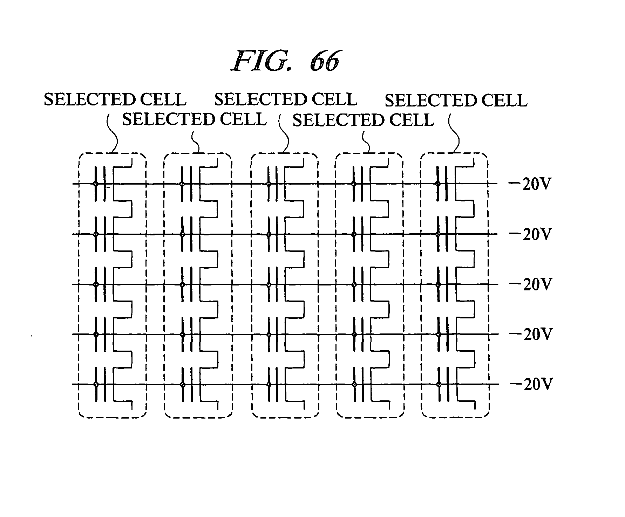

FIG. 65 shows voltages during a data write operation. The data write operation is performed using a tunnel current through the first gate dielectric film 4. Data is written to the memory cells connected to the selected word line WL. A voltage of 0V is applied to both ends of the memory cell column including the selected memory cell under the selected word line WL, and a voltage of 0V is applied to the p-type well 2. In this state, the potential of each non-selected word line WL is suddenly increased from 0V to about 10V within time in microseconds or less. Next, the potential of the selected word line WL is increased from 0V to about 20V. On a bit line on which the potential of the principal surface of the substrate 1 is 0V, a large potential difference is generated between the floating gate 7 and the principal surface of the substrate 1, and electrons are injected from the principal surface into the floating gate 7 by the tunnel current, whereby data is written to the memory cells.

FIG. 66 shows voltages during a data erasure operation. During the data erasure operation, a voltage of about -20V is applied to all the word lines WL put between the selected transistors, and electrons are emitted from the floating gate 7 to the substrate 1 by Fowler-Nordheim tunnel current through the first gate dielectric film 4.

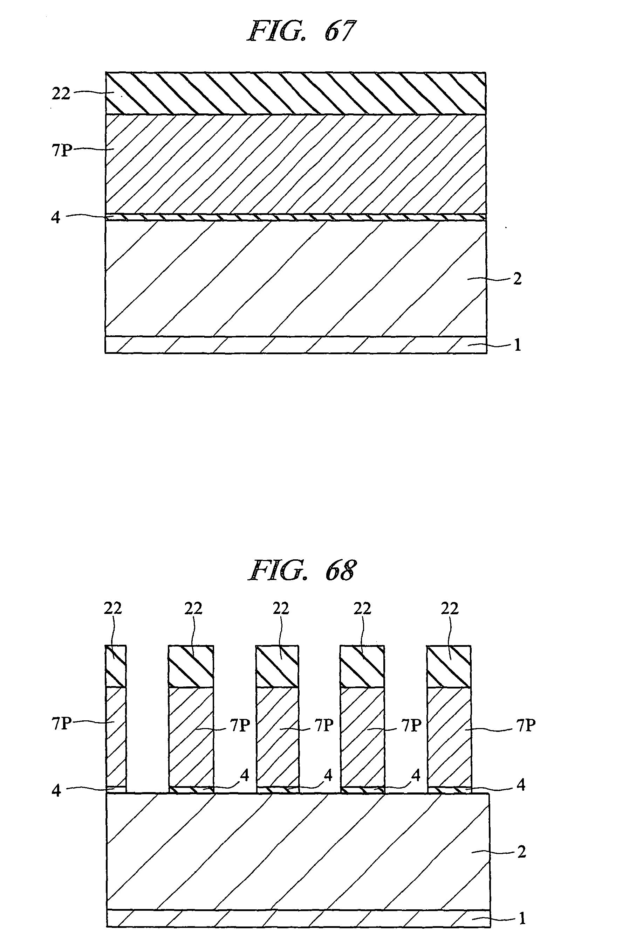

An example of a method of manufacturing the flash memory according to the fourth embodiment will be described with reference to FIGs. 67 to 76.

As shown in FIG. 67, similarly to the first embodiment, the p-type well 2 is formed on the substrate 1(which is the semiconductor wafer at this stage), and the first gate dielectric film 4 having a thickness of about nine 9nm is formed on the principal surface of the substrate 1 by thermal oxidation. A phosphorus (P)-doped polycrystalline silicon film 7P served as the floating gate 7 and a silicon nitride film 22 served as an etching mask are deposited by ordinary CVD. FIG. 67 is a cross-sectional view taken along a line corresponding to the line I-I' of FIG. 61.

As shown in FIG. 68, the silicon nitride film 22 is patterned into stripes by lithography and anisotropic etching. Thereafter, the polycrystalline silicon film 7P and the first gate dielectric film 4 are etched using the silicon nitride film 22 as a mask, thereby exposing the substrate 1. FIG. 68 is a cross-sectional view taken along a line corresponding to the line I-I' of FIG. 61.

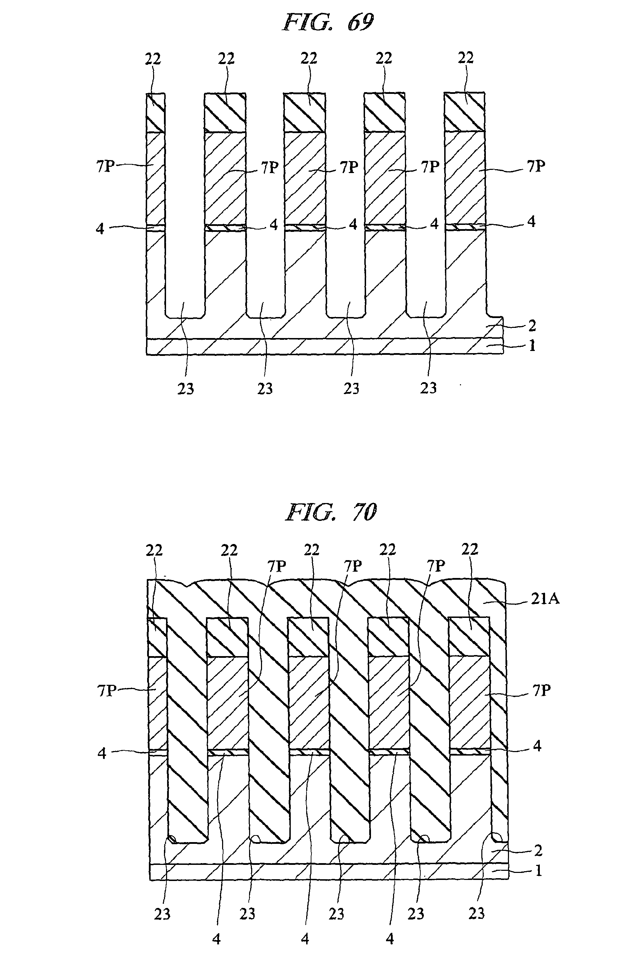

As shown in FIG. 69, using the pattern of the silicon nitride film 22 as a mask, an etching treatment is performed to form a groove 23 in the principal surface of the substrate 1. FIG. 69 is a cross-sectional view taken along a line corresponding to the line I-I' of FIG. 61.

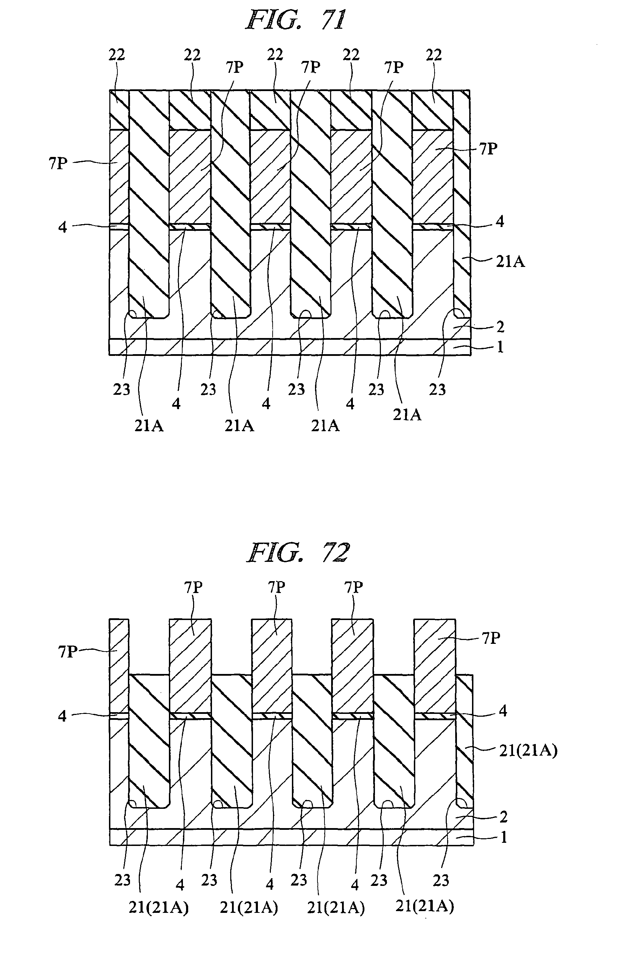

As shown in FIG. 70, a silicon dioxide film 21A is deposited on the principal surface of the substrate 1. FIG. 70 is a cross-sectional view taken along a line corresponding to the line I-I' of FIG. 61. Thereafter, as shown in FIG. 71, an upper portion of the silicon dioxide film 21A is polished and flattened by the CMP using the silicon nitride film 22 as a stopper. FIG. 71 is a cross-sectional view taken along a line corresponding to the line I-I' of FIG. 61. The silicon nitride film 22 is removed by dry etching or wet etching, and the upper surface of the remaining silicon dioxide film 21A is etched by dry etching, thereby forming the isolation region 21 as shown in FIG. 72. The isolation region 21 is formed by burying the silicon dioxide film 21A in the groove 23. FIG. 72 is a cross-sectional view taken along a line corresponding to the line I-I' of FIG. 61.

A high-dielectric-constant film to serve as the second gate dielectric film 5 is deposited. This high-dielectric-constant film can be made of alumina (Al₂O₃). Thereafter, the phosphorus (P)-doped n-type polycrystalline silicon film 8A, the tungsten nitride film 8B, the tungsten film 8C, and the silicon dioxide film 12 are deposited from the bottom in this order by the CVD or the like. A cross-sectional view taken along a line corresponding to the line I-I' of FIG. 61 at this stage is identical to FIG. 62.

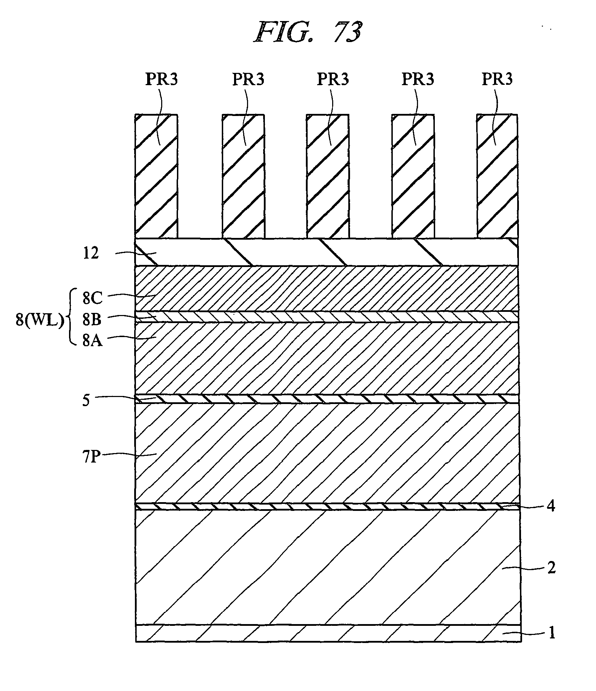

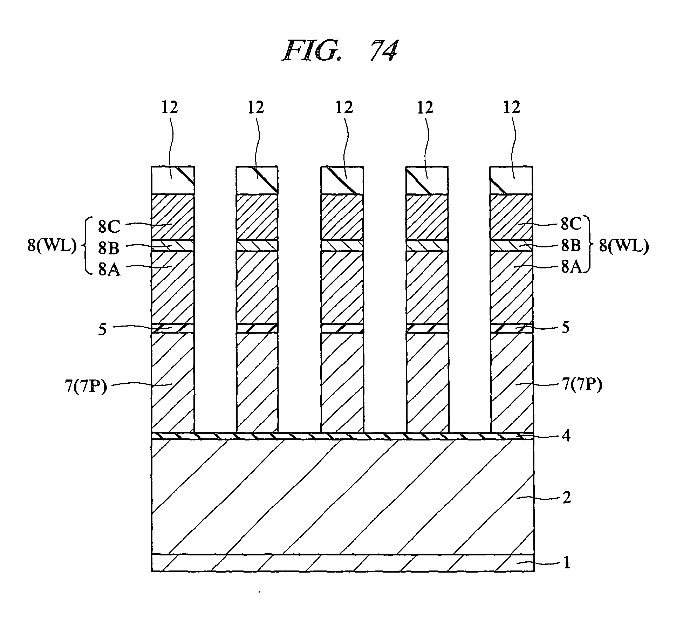

As shown in FIG. 73, a photoresist PR3 in a pattern of stripes extending in the X direction is formed by lithography. FIG. 73 is a cross-sectional view taken along a line corresponding to the line J-J' of FIG. 61. Using the photoresist PR3 as a mask, the silicon dioxide film 12 is etched. After removing the photoresist PR3, dry etching is performed using the remaining silicon dioxide film 12 as a mask, thereby integrally processing (etching) the tungsten film 8C, the tungsten nitride film 8B, the n-type polycrystalline silicon film 8A, the second gate dielectric film 5, and the polycrystalline silicon film 7P as shown in FIG. 74. The floating gate 7 and the control gate 8 (word line WL) are thereby formed. FIG. 74 is a cross-sectional view taken along a line corresponding to the line J-J' of FIG. 61.

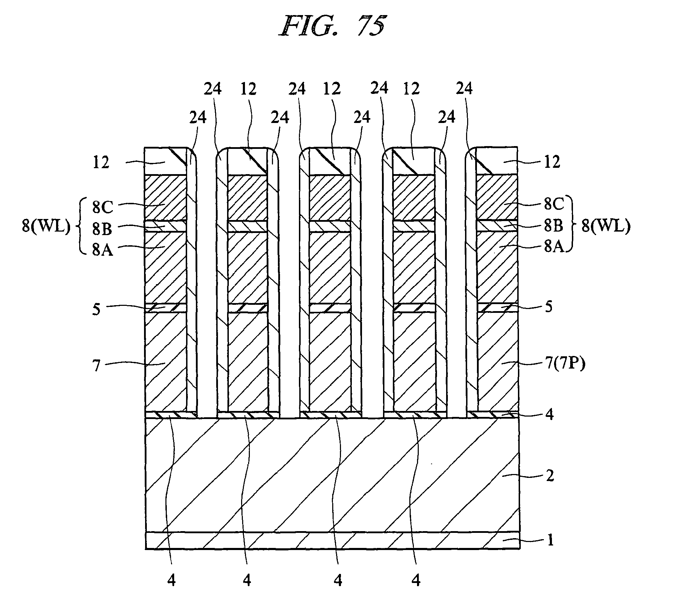

Thereafter, a silicon dioxide film is conformally deposited by the CVD and etched back by anisotropic etching to expose a part of the principal surface of the substrate 1, thereby forming sidewalls 24 on side walls of a pattern of the tungsten film 8C, the tungsten nitride film 8B, the polycrystalline silicon film 8A, the second gate dielectric film 5, and the polycrystalline silicon film 7P (floating gate 7) as shown in FIG. 75. FIG. 75 is a cross-sectional view taken along a line corresponding to the line J-J' of FIG. 61.

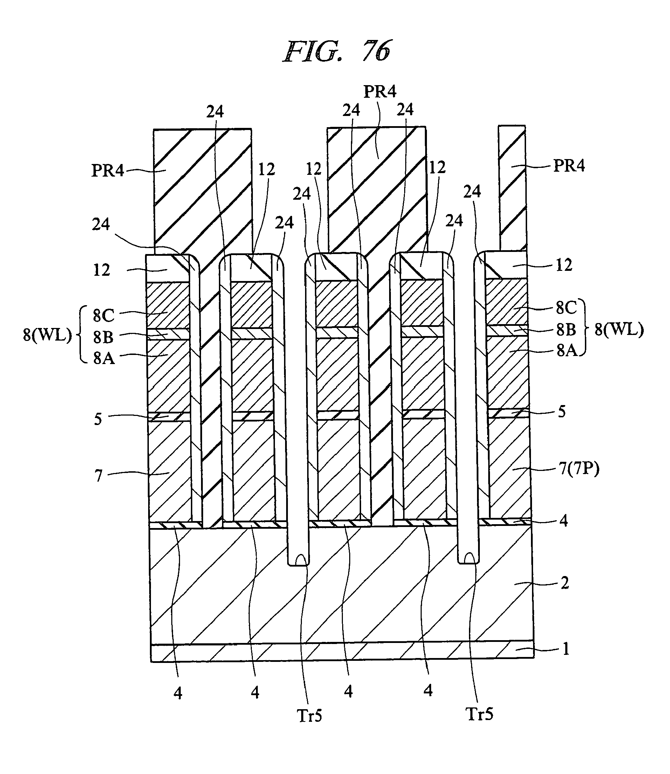

As shown in FIG. 76, a photoresist PR4 in a pattern of stripes extending in the X direction is formed on the principal surface of the substrate by lithography. Using the photoresist PR4 as a mask, the principal surface of the substrate 1 exposed from the photoresist PR4 is etched, thereby forming the groove Tr5. FIG. 76 is a cross-sectional view taken along a line corresponding to the line J-J' of FIG. 61.

Next, n-type impurity ions such as phosphorus (P) ions are implanted, thereby forming the n-type diffusion layer 3 (3a, 3b) on the bottom side of the groove Tr5 of the substrate 1 as shown in FIG. 63.

Thereafter, although not shown, after an interlayer dielectric film is formed, contact holes for feeding voltages to the word lines WL, the well, the memory cells and the like are formed, and a metal film is deposited and patterned into wirings, thereby forming a memory cell.

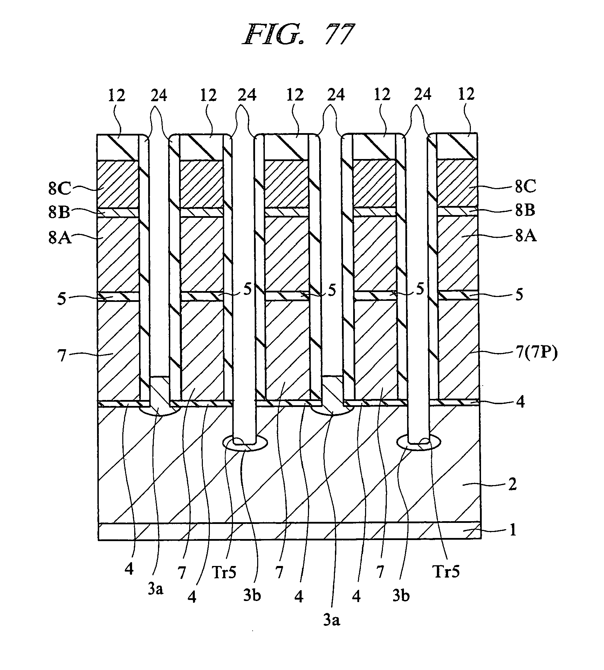

Furthermore, in case of the memory cell array in which the memory cells are connected in series as described in the fourth embodiment, if the resistance of the connected memory columns is high, the high resistance disadvantageously causes erroneous decision during a data read operation. To deal with the disadvantage, after formation of the sidewall 24 and before formation of the groove Tr5 by etching the substrate 1, n-type silicon is subjected to crystal growth on the principal surface of the substrate 1 by selective epitaxial growth technique and form n-type diffusion layer 3a. As shown in FIG. 77, by implanting desired impurities into a crystal layer made of the n-type silicon, the resistance of the n-type diffusion layer 3 can be reduced and that of the memory cell column can be reduced accordingly.

Generally, if each nonvolatile memory cell in which electric charges are stored in the floating gate 7 is further downsized and the distance between the adjacent memory cells is thereby shorter, the electro-static capacitance between the adjacent floating gates 7 is increased. Therefore, if the potential of a certain floating gate 7 changes, the potential of the other floating gate 7 adjacent thereto also changes, which causes data erroneous decision during the data read operation. According to the fourth embodiment, by contrast, n-type silicon that is a conductor is grown by selective epitaxial growth between the adjacent floating gates 7, whereby it is possible to electrostatically shield the adjacent floating gates 7 from each other. It is thereby possible to decrease a probability of data erroneous decision.

As described in the first embodiment, if the source-side and drain-side n-type diffusion layers 3 of the memory cell are offset (that is, the source-side and drain-side n-type diffusion layers 3 are formed at deep positions apart from the principal surface of the substrate 1), the short-channel-effect tolerance is deteriorated. By offsetting only one of the n-type diffusion layers 3 (that is, forming one of the source-side and drain-side n-type diffusion layers 3 at the deep position apart from the principal surface of the substrate 1) as described in the fourth embodiment, the high short-channel-effect tolerance can be attained.

The present invention has been specifically described based on the embodiments of the present invention. Needless to say, the present invention is not limited to the embodiments and various changes and modifications can be made of the present invention within the scope of the invention.

For example, in the first to fourth embodiments, the instance in which the groove is formed in the substrate 1 and each n-type diffusion layer 3 is formed on the bottom side of the groove has been described. However, the present invention is not limited to the instance. Alternatively, one of the n-type diffusion layers 3 can be formed at a deep position apart from the principal surface of the substrate 1 by adjusting, for example, impurity-implantation energy during formation of the n-type diffusion layers. In this alternative, after the step shown in FIG. 15, during implantation of impurity ions for forming one of the n-type diffusion layers 3 on the principal surface of the substrate 1, a region in which the other n-type diffusion layer 3 is to be formed is covered with a photoresist film. In addition, during implantation of impurity ions for forming the other n-type diffusion layer 3 deep in the substrate 1, a region in which one n-type diffusion layer 3 is to be formed is covered with a photoresist film.

The instance in which the invention made by the present inventors is applied to the nonvolatile semiconductor memory device in the field of background of the invention has been mainly described. However, the present invention is not limited to the nonvolatile semiconductor memory device and applicable to various other semiconductor devices. For example, the present invention can be applied to a semiconductor device configured so that a nonvolatile semiconductor memory circuit and a logic circuit such as a microprocessor are present on the same substrate.

The nonvolatile semiconductor memory device according to the present invention is suited for use as a storage device for a small-sized portable information apparatus such as a portable personal computer or digital still camera.

## Claims

1. A semiconductor device comprising a memory cell, constituted by a field effect transistor, the field-effect transistor including:
a first gate electrode formed on a semiconductor substrate of a first electric conduction type through a first gate dielectric film;
a second gate electrode formed on the first gate electrode through a second gate dielectric film;
a third gate electrode formed on the semiconductor substrate through a third gate dielectric film; and
a diffusion layer of a second electric conduction type formed on a bottom side of a groove formed in the semiconductor substrate,
wherein the second gate electrode constitutes a word line, and
the diffusion layer constitutes a data line.

2. The semiconductor device according to claim 1,
wherein the data line constituted by the diffusion layer is formed in a direction orthogonal to the word line.

3. The semiconductor device according to claim 1,
wherein an inversion layer formed on the semiconductor substrate at a time of applying a voltage to the third gate electrode constitutes the data line.

4. The semiconductor device according to claim 2,
wherein when information is written from the memory cell, the data line constituted by the diffusion layer is used, and
when the information is read to the memory cell, the data line constituted by the inversion layer and the diffusion layer is used, the inversion layer being formed on the semiconductor substrate by applying a voltage to the third gate electrode.

5. A semiconductor device comprising a memory cell, constituted by a field-effect transistor, the field-effect transistor including:
a first gate electrode formed on a semiconductor substrate of a first electric conduction type through a first gate dielectric film;
a second gate electrode formed on the first gate electrode through a second gate dielectric film; and
a diffusion layer of a second electric conduction type formed on the semiconductor substrate,
wherein the second gate electrode constitutes a word line,
the diffusion layer constitutes a data line, and
a first electrode is formed on the data line constituted by the diffusion layer through a dielectric film.

6. The semiconductor device according to claim 5,
wherein a potential of the data line constituted by the diffusion layer is controlled by controlling a potential of the first electrode.

7. A semiconductor device including a memory cell, constituted by a field-effect transistor, the field-effect transistor comprising:
a first gate electrode formed on a semiconductor substrate of a first electric conduction type through a first gate dielectric film;
a second gate electrode formed on the first gate electrode through a second gate dielectric film;
a third gate electrode formed on the semiconductor substrate through a third gate dielectric film; and
a diffusion layer of a second electric conduction type formed on the semiconductor substrate,
wherein the first gate electrode and the third gate electrode are not present on a same plane,
the second gate electrode constitutes a word line,
the diffusion layer constitutes a data line, and
a first electrode is formed on the data line constituted by the diffusion layer through a dielectric film.

8. A semiconductor device comprising a plurality of memory cells each constituted by a field-effect transistor, the field-effect transistor including:
a first gate electrode formed on a semiconductor substrate of a first electric conduction type through a first gate dielectric film;
a second gate electrode formed on the first gate electrode through a second gate dielectric film;
a groove formed in the semiconductor substrate; and
a diffusion layer of a second conduction type formed on a bottom side of the groove on the semiconductor substrate,
wherein the second gate electrode constitutes a word line, and
the diffusion layer constitutes a data line.

9. The semiconductor device according to claim 8,
wherein the plurality of memory cells arranged along the data line are connected in series.

10. The semiconductor device according to claim 9,
wherein an isolation is provided between adjacent memory cells of the plurality of memory cells arranged along the word line on the semiconductor substrate.

11. A semiconductor device comprising:
(a) a semiconductor substrate including a principal surface and a rear surface opposite to each other in a thickness direction;
(b) a plurality of first gate electrodes formed on the principal surface of the semiconductor substrate through a first gate dielectric film;
(c) a plurality of word lines extending in a first direction along the principal surface of the semiconductor substrate, and arranged to be aligned to one another in a second direction crossing the first direction;
(d) a plurality of second gate electrodes formed by parts of the plurality of word lines, and formed in portions in which the plurality of word lines are overlapped with the plurality of first gate electrodes so as to be insulated from the plurality of first gate electrodes by a second gate dielectric film;
(e) a plurality of third gate electrodes arranged in every other area among the adjacent electrodes of the plurality of first gate electrodes aligned in the first direction, formed to extend in the second direction along the principal surface of the semiconductor substrate, and formed on the principal surface of the semiconductor substrate through a third gate dielectric film; and
(f) a diffusion layer formed in areas where the third electrodes are not arranged out of a plurality of areas among the adjacent first gate electrodes aligned in the first direction on the principal surface of the semiconductor substrate,
wherein the diffusion layer is formed at a deeper position than a position of the principal surface of the semiconductor substrate, to which the third gate electrodes are opposed, on the semiconductor substrate.

12. The semiconductor device according to claim 11, wherein the diffusion layer is formed on a bottom side of a groove formed in areas where the third electrodes are not arranged out of plurality of areas among the adjacent first gate electrodes aligned in the first direction on the principal surface of the semiconductor substrate.

13. A semiconductor device comprising:
(a) a semiconductor substrate including a principal surface and a rear surface opposite to each other in a thickness direction;
(b) a plurality of first gate electrodes formed on the principal surface of the semiconductor substrate through a first gate dielectric film;
(c) a plurality of word lines extending in a first direction along the principal surface of the semiconductor substrate, and arranged to be aligned to one another in a second direction crossing the first direction;
(d) a plurality of second gate electrodes formed by parts of the plurality of word lines, and formed in portions in which the plurality of word lines are overlapped with the plurality of first gate electrodes so as to be insulated from the plurality of first gate electrodes by a second gate dielectric film;
(e) an isolating unit arranged between adjacent of first gate electrodes of the plurality of first gate electrodes aligned in the first direction; and
(f) a plurality of diffusion layers each formed in area among the adjacent first gate electrodes aligned in the second direction on the principal surface of the semiconductor substrate,
wherein the adjacent diffusion layers in the second direction among the plurality of diffusion layers differ from each other in a position in a depth direction of the semiconductor substrate.

14. The semiconductor device according to claim 13,
wherein one of adjacent diffusion layers among the plurality of diffusion layers aligned in the second direction is formed on the principal surface of the semiconductor substrate, and other one of the adjacent diffusion layers is formed on a bottom side of a groove formed in the principal surface of the semiconductor substrate.
